(19) Europäisches Patentamt
European Patent Office
Office européen des brevets

(11) EP 3 759 741 B1

(12) **EUROPEAN PATENT SPECIFICATION**

(45) Date of publication and mention
of the grant of the patent:
**12.07.2023 Bulletin 2023/28**

(21) Application number: **19710071.2**

(22) Date of filing: **26.02.2019**

(51) International Patent Classification (IPC):
***H01L 29/786*** *(2006.01)*    ***H01L 29/78*** *(2006.01)*
***H01L 29/66*** *(2006.01)*

(52) Cooperative Patent Classification (CPC):
**H01L 29/7869; H01L 29/66643; H01L 29/66969;
H01L 29/7839**

(86) International application number:
**PCT/GB2019/050522**

(87) International publication number:
**WO 2019/166791 (06.09.2019 Gazette 2019/36)**

(54) **SCHOTTKY BARRIER THIN FILM TRANSISTOR AND METHOD**

DÜNNFILMTRANSISTOR MIT SCHOTTKY-BARRIERE UND METHODE

TRANSISTOR À COUCHE MINCE À BARRIÈRE DE SCHOTTKY ET PROCÉDÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.02.2018 GB 201803169
21.12.2018 GB 201821078**

(43) Date of publication of application:
**06.01.2021 Bulletin 2021/01**

(73) Proprietor: **Song, Aimin
Altrincham Cheshire WA15 6QS (GB)**

(72) Inventors:
• **SONG, Aimin
Manchester M13 9PL (GB)**
• **ZHANG, Jiawei
Manchester M13 9PL (GB)**
• **WILSON, Joshua
Manchester M13 9PL (GB)**

(74) Representative: **Appleyard Lees IP LLP
15 Clare Road
Halifax HX1 2HY (GB)**

(56) References cited:
**EP-A1- 2 339 638       US-A1- 2010 258 802
US-A1- 2017 250 287**

## Description

### Field

The present invention relates to methods of forming Schottky source contacts on oxide semiconductor channels for Schottky barrier thin-film transistors

### Background to the invention

Generally, a Schottky barrier thin-film transistor (SBTFT) (also known as a source-gated transistor, SGT, or a Schottky source transistor, SST) comprises a stack including a gate insulator layer, a semiconductor channel overlaying the gate insulator layer, a source contact overlaying at least a part of the semiconductor channel, a drain contact and a gate contact. The source contact, the gate contact and the drain contact are mutually spaced. The source contact extends across a source region of the semiconductor channel defining a Schottky potential barrier between the source contact and the source region of the semiconductor channel. The gate contact controls transport of carriers from the source contact to the source region of the semiconductor channel across the barrier when the source region is depleted.

Oxide semiconductors, particularly indium-gallium-zinc-oxide (IGZO), are now reaching the maturity required for thin-film electronic applications. However, application of standard oxide semiconductor TFTs for example in displays, is limited by their relatively low intrinsic gains, short-channel effects and negative bias illumination temperature stresses (NBITS).

EP2339638 A1 described a transistor including a semiconductor insertion layer between a channel layer and a source electrode. US2010/258802 A1 describes an n-channel transistor and a p-channel transistor having a preferred structure using an oxide semiconductor. US2017/250287 A1 describes a Schottky source-gated thin film transistor including: a drain contact; an insulating substrate; a source contact made of a Schottky metal; a channel connecting the buried source contact to the drain, the channel made of ZnO; and a Schottky source barrier formed between the source contact and the channel; and a gate; wherein the source contact is positioned below the channel.

Hence, there is a need to improve oxide semiconductor TFTs.

### Summary of the invention

It is an aim of embodiments of the invention to provide a method of forming a Schottky source contact upon an oxide semiconductor channel that improves an intrinsic gain, a short channel effect and/or a negative bias illumination temperature stress. According to a first aspect that is not claimed, there is provided a Schottky barrier thin-film transistor, SBTFT, comprising a Schottky source contact on an oxide semiconductor channel, the SBTFT having an intrinsic gain of at least 500.

According to the second aspect that is not claimed, there is provided an inverter, a logic gate, an integrated circuit, an analogue circuit or a display comprising a Schottky barrier thin-film transistor according to the first aspect.

According to a third aspect, there is provided a method according to claim 1.

### Detailed Description of the Invention

According to the present invention there is provided a method of forming a Schottky source contact on an oxide semiconductor channel for a Schottky barrier thin-film transistor. Other features of the invention will be apparent from the dependent claims, and the description that follows.

#### *SBTFT comprising a Schottky source contact on an oxide semiconductor channel*

According to the first aspect that is not claimed, there is provided a Schottky barrier thin-film transistor, SBTFT, comprising a Schottky source contact on an oxide semiconductor channel, the SBTFT having an intrinsic gain of at least 500.

In this way, since the SBTFT has a relatively high intrinsic gain of at least 500, the SBTFT is suitable for use in an inverter, for example, and for application in large-area displays, in logic gates and in analogue circuits, for example. Furthermore, the SBTFT may have an improved short channel effect and/or an improved negative bias illumination temperature stress, as described below in more detail.

Transistors are the bedrock of the recent technology revolutions that have shaped the modern world. In order to drive further advancement, new transistors must be designed to meet industry needs. One unconventional transistor design combines the thin-film transistor (TFT) with another fundamental component of electronics, the Schottky diode. The advantages of the resulting Schottky barrier thin-film transistor (SBTFT) include high intrinsic gain, low-voltage saturation, insensitivity to channel length and semiconductor quality and improved stability.

Within the literature, SBTFTs with common designs and characteristics are given various names, such as Schottky barrier thin-film transistors, source-gated transistors and tunnelling contact transistors. Under these different names, conflicting theories of device operation continue to be put forward. For example, the gate dependence of the current has been variously attributed to lowering of the source barrier height, increased tunnelling current and modulation of the effective source length. There are also differing claims about the effects of using a Schottky drain contact. Similarly, diode reverse current saturation, tunnelling and depletion of the semiconductor by the source have all been suggested as causes of current saturation.

Parallel to the development of the Schottky barrier thin-film transistors, breakthroughs of oxide semiconductor devices have opened a new era in microelectronics, particularly for large-area, flexible and transparent applications. The wide bandgap of oxide semiconductors (typically > 3 eV) allows for high optical transparency, while room-temperature processability offers compatibility with flexible substrates. Although oxide semiconductors, particularly indium-gallium-zinc-oxide (IGZO), are nearing maturity, but there remain major barriers to large-scale adoption. Foremost among these is negative bias illumination temperature stress (NBITS). When IGZO TFTs are held at negative gate bias, elevated temperature and illuminated with near-bandgap energy photons there is a negative shift in the turn-on voltage. Thus far, susceptibility to NBITS is the main factor delaying the wide-scale adoption of IGZO as a replacement for polysilicon and amorphous silicon in the display industry.

Of similar importance is the issue of device scaling. To maintain improvements in electronic circuits the density of transistors must be increased; hence transistor size must be reduced. Reducing the length of the channel between the source and drain contacts below a certain value will degrade the transistor characteristics. In particular, reduced on/off ratio and gain preclude the use of short-channel transistors as drivers in displays.

In this work, TFTs exhibiting extremely high gain are designed by adapting our new understanding of reverse-biased thin-film Schottky diodes. Based on these designs and derived analytical theory, oxide semiconductor TFTs with intrinsic gains consistently above 10,000, peaking around 29,000, are demonstrated. Furthermore, for the first time, the inventors have produced oxide semiconductor TFTs that are intrinsically impervious to NBITS. Moreover, these same devices show no indication of the short-channel effect down to 360 nm. Finally, our design no longer restricts the channel layer to being a semiconductor, as demonstrated by using a semi-metal-like oxide, indium tin oxide (ITO).

In a classical model of a SBTFT comprising a Schottky source contact on a semiconductor channel at zero bias, a conduction band energy $E_C$ in the semiconductor is a maximum (i.e. the source barrier height $\Phi_B$) at the interface between the Schottky source contact and the semiconductor channel. The conduction band energy $E_C$ decreases away from the interface in the semiconductor channel. Generally, SBTFTs require source barrier heights $\Phi_B$ of ~ 0.3 eV - 0.5 eV in order to deplete the semiconductor channel while still achieving sufficiently high current for application.

The classical model assumes that the Schottky source contact and the semiconductor are homogeneous. The inventors have determined that this classical model may not apply to Schottky source contacts on oxide semiconductor channels, due to heterogeneities (also known as inhomogeneities) therein. The heterogeneities may be nanoscale and may arise, for example, from compositional inhomogeneities in the oxide semiconductor and/or the source contact, oxygen depletion in regions of the oxide semiconductor such as proximal the interface, (poly)crystalline and/or amorphous variations and/or crystallographic work function dependence of the source contact.

In contrast to the classical model, for a SBTFT having a source contact on an oxide semiconductor channel, a conduction band energy $E_C$ in the oxide semiconductor may instead increase away from the interface between the source contact and the oxide semiconductor channel. In this way, an effective source barrier height $\Phi_B^e$ may be exhibited in the oxide semiconductor channel at a height greater than the source barrier height $\Phi_B$ at the interface. In a direction perpendicular to the interface between the Schottky source contact and the semiconductor channel, the conduction band minimum $E_C$ of the oxide semiconductor channel may increase when a source region of lower barrier height is surrounded by source regions of higher barrier height. Thus, a saddle point SP in the conduction band minimum $E_C$ may be formed. The saddle point SP offers the most favourable current path and the effective source barrier height $\Phi_B^e$ is defined by the most favourable current paths. As a result of a plurality of inhomogeneities, for example at the nanoscale, there may be a corresponding plurality of such saddle points SP providing and/or contributing to the effective source barrier height $\Phi_B^e$. Particularly, the inventors have determined that a problem with the saddle point *SP* is its strong voltage dependence, leading to a voltage dependent barrier height. As a drain voltage $V_D$ increases, the saddle point *SP* becomes lower and more current can pass over the barrier, as described below in more detail. This increase in current with drain voltage $V_D$ degrades the intrinsic gain. That is, the heterogeneities may, at least in part, dominate behaviour of the SBTFT by providing regions having higher, as well as lower, source barrier heights. Particularly, as discussed below in more detail, the lower barrier regions provided at least in part by these barrier heterogeneities may be deterministic in controlling the behaviour of the SBTFT.

The inventors have determined that, in order for the source contact to behave as a Schottky source contact on the oxide semiconductor channel as desired, the effective source barrier height $\Phi_B^e$ should be reduced towards, and preferably below, the source barrier height $\Phi_B$ at the interface. The inventors have determined that this may be achieved by, at least in part, controlling a thickness of the oxide semiconductor channel (i.e. the oxide semiconductor channel thickness $H$) and/or the heterogeneities, so as to control behaviour of the SBTFT and/or dominance of the heterogeneities on the behaviour.

Preferably, a goal is to remove the saddle point $SP$ so that the effective barrier height $\Phi_B^e$, and therefore the current, is no longer strongly dependent upon the applied voltage. Reducing the oxide semiconductor channel thickness $H$ may move the saddle point $SP$ closer to the interface between the oxide semiconductor channel and the source contact until the saddle point $SP$ eventually disappears entirely.

Particularly, the inventors have determined, as described below in more detail, that the effective source barrier height $\Phi_B^e$ may be reduced by controlling the saddle point SP in the oxide semiconductor channel. Controlling the saddle point SP may be, for example, by reducing the height of the saddle point $SP$ and hence the effective source barrier height $\Phi_B^e$, by reducing a distance of the saddle point $SP$ from the interface or even by eliminating the saddle point $SP$ entirely. That is, reducing the effective source barrier height $\Phi_B^e$ may not only be by reducing the height of the saddle point $SP$ but may also be by moving its position within the oxide semiconductor channel.

The inventors have determined, as described below in more detail, that if the oxide semiconductor channel thickness $H$ is too large, the height of the saddle point $SP$ and/or the distance of the saddle point from the interface may be too large and hence the effective source barrier height $\Phi_B^e$ too high for the Schottky source contact to behave as desired i.e. without a bias dependence of the barrier height, caused by the saddle point $SP$. Conversely, the inventors have determined, as described below in more detail, that if the oxide semiconductor channel thickness $H$ is too small, an electric field in use becomes so large that tunnelling and other barrier lowering mechanisms additionally affect a saturation current of an output curve of the SBTFT.

Treatment of the oxide semiconductor channel may be typically carried out to increase a conductivity thereof, prior to deposition of the source contact thereon, for example by annealing or by argon plasma treatment. However, surface regions, or even a through thickness, of the oxide semiconductor channel may become depleted with respect to oxygen during the treatment, for example during the annealing. The inventors have determined, as described below in more detail, that this depletion of the oxide semiconductor channel with respect to oxygen may result in heterogeneities that adversely affect the Schottky source contact behaviour. The inventors have determined, as described below in more detail, that depositing the source contact on the oxide semiconductor channel in the presence of oxygen may result in beneficial treatment of the oxygen-depleted surface regions of the oxide semiconductor and/or formation of a beneficial interface layer including the oxygen, as described below in more detail.

Through the constructive use of barrier height inhomogeneities and the resulting thickness dependence of the barrier height at the source contact, the inventors have overcome the conventional problems associated with oxide semiconductor, for example IGZO, SBTFT fabrication. Particularly, the inventors have successfully fabricated oxide semiconductor, for example IGZO, SBTFTs having extremely high intrinsic gains, an unprecedented robustness to reduced channel length and excellent stability under NBITS.

These SBTFTs are suitable for application in displays such as large-area displays, in logic gates and in analogue circuits, for example. Furthermore, the low-voltage saturation of these SBTFTs significantly reduces power consumption, making them useful for battery-powered wearable devices, for example.

Generally, a conventional Schottky barrier thin-film transistor (SBTFT) employs a Schottky contact at the source (i.e. a Schottky source contact) to modulate the drain current $I_D$, making the drain current $I_D$ independent of the semiconductor channel.

In order to operate as a conventional SBTFT, there are three basic design rules:

(a) the gate contact must overlap with the Schottky source contact;
(b) the semiconductor channel must be sufficiently conductive to not limit the drain current $I_D$; and
(c) the semiconductor channel must be thin enough to be fully depleted by the reverse biased source.

The conventional SBTFT structure has been applied to various semiconductor channel layers including amorphous Si:H, poly-Si, ZnO , ZnO nanosheets and ZnO nanowires. Thus far, conventional SBTFTs fabricated using oxide semiconductors show quite poor properties, which may be due to poor Schottky source contact and/or low channel conductivities.

Generally, SBTFTs require source barrier heights of ∼ 0.3 - 0.5 eV in order to deplete the semiconductor while still achieving sufficiently high current for application. For oxide semiconductors, achieving uniform Schottky contacts with such low barrier heights may be difficult. Furthermore, barrier height inhomogeneities are typically prevalent in thin-film Schottky diodes fabricated with oxide semiconductors and have been shown to significantly degrade reverse bias $J$ - $V$ characteristics of these diodes. Thus far, all discussions in the literature of the operating mechanism of SBTFTs have assumed a homogeneous barrier at the source contact. As the operating mechanism of SBTFTs relies so heavily upon the behaviour of the reverse biased Schottky barrier at the source, it is important to obtain a keen understanding of the effects of barrier height variations.

Herein, oxide semiconductor, particularly IGZO, SBTFTs exhibiting extremely high-gain, unprecedented stability to NBITS and short-channel effects are described. Firstly, the inventors have produced conductive IGZO channels by thermally annealing in an inert atmosphere. However, a Schottky junction formed on IGZO, or any other disordered semiconductor, may have an inhomogeneous barrier height. Barrier inhomogeneities lead to the formation of saddle points in the conduction band minimum, such that the saddle point serves as an effective barrier height with a strong bias dependence. To maximise the intrinsic gain, the saddle points should be removed and/or their effects lessened. The inventors have achieved this through two mechanisms:

1. from SBTFT simulations, it has been established that the saddle points can be removed by reducing the thickness of the semiconductor;
2. by controlling barrier inhomogeneities using sputtering power and the presence of oxygen during source contact deposition.

Through these two mechanisms, intrinsic gains consistently above 1,000 are demonstrated. Finally, the inventors have demonstrated that these SBTFTs are impervious to the short-channel effect down to 800 nm and are extremely stable under NBITS.

For oxide semiconductors, oxygen deficiencies are expected to cause inhomogeneities in Schottky source contacts. However, a method of fabrication described herein is applicable to all oxide semiconductors. Moreover, simulations of the SBTFTs having an inhomogeneous Schottky source contact offer a deeper understanding of SBTFT behaviour that will be of use in other disordered semiconductor systems, for example organics. The methods described herein are also compatible with complementary metal oxide circuits. Indeed, the use of Pt, for example, as a Schottky source contact on an n-type oxide semiconductor enables use of single-step contact deposition for both n-type and p-type transistors. While a current in SBTFTs may be relatively lower than standard TFTs, simulations suggest that the current produced by an oxide semiconductor, for example IGZO, SBTFT may be compatible with AMOLED displays, for example.

The inventors have determined a new design rule for these oxide semiconductor channel SBTFTs: in order for the source contact to behave as a Schottky source contact on the oxide semiconductor channel that is not strongly affected by the drain bias voltage (i.e. as desired), the effective source barrier height $\Phi_B^e$ should be reduced towards, and preferably below, the source barrier height $\Phi_B$ at the interface. The inventors have determined that this may be achieved by, at least in part, controlling a thickness of the oxide semiconductor channel (i.e. the oxide semiconductor channel thickness $H$) and/or the heterogeneities, so as to control behaviour of the SBTFT and/or dominance of the heterogeneities on the behaviour. In other words, for inhomogeneous barriers, the thickness of the oxide semiconductor channel (i.e. the oxide semiconductor channel thickness $H$) should be reduced such that the saddle point $SP$ is removed or sufficiently close to the interface between the Schottky source contact and the oxide semiconductor channel, without being so thin as to induced a high enough electric field as to reduce the gain or deplete the oxide semiconductor channel of electrons so as to make the operating voltages impractically large. Using this new design rule, the inventors have successfully fabricated oxide semiconductor, for example IGZO, SBTFTs with ultra-high intrinsic gains. This result owes much to a detailed understanding of disorder at the interface between the Schottky source contact and the oxide semiconductor, which is useful understanding for other disordered materials. Furthermore, these SBTFTs also show excellent insensitivity to short-channel effects and NBTIS. Individually, these are excellent improvements upon the state of the art, but combined, they signify a major advance in SBTFT technology.

*Intrinsic gain*

As described in more detail below, the intrinsic gain $A_V$ of a SBTFT may be considered to be a figure of merit thereof. The SBTFT has the intrinsic gain of at least 500. In one example, the intrinsic gain is preferably at least 1,000, more preferably at least 2,000, most preferably at least 3,000, at least 5,000, at least 8,000 or at least 10,000. In one example, the intrinsic gain is at most 50,000, at most 45,000, at most 40,000, at most 35,000, at most 30,000, at most 25,000, at most 20,000, at most 10,000.

*NBITS*

Negative Bias Illumination Temperature Stress (NBITS) may cause the threshold voltage of conventional SBTFTs to shift negatively during use. In one example, a change in an on voltage $V_{ON}$ of the SBTFT after illumination for 30 minutes, preferably 45 minutes by a white LED, at approximately 2000 lx, at a spacing of 3 cm from the SBTFT, at a bias voltage of -20 V, at a gate voltage of 20 V and at 80 °C is at most 10 %, preferably at most 5%, more preferably at most 1 %.

*Short channel effect*

Short channel effects may cause a problem for device scaling, due to the source contact being shielded from the drain contact. In one example, the SBTFT exhibits flat saturation up to a drain voltage $V_D$ of 20 V at down to a channel length $L_{CH}$ of 2 $\mu$m, preferably 1 $\mu$m, more preferably 0.8 $\mu$m.

*Effective barrier height*

In one example, an effective barrier height of the Schottky source contact is substantially independent of a drain voltage $V_D$ of the SBTFT, in use. In this way, saddle points *SP* are reduced and/or removed. By substantially independent, it should be understood that other factors, such as image force lowering, may still provide a dependence of the drain voltage $V_D$ but are not significant, in use.

In one example, a maximum potential of a conduction band minimum (i.e. a saddle point) of the oxide semiconductor channel at zero bias is within 10 nm, preferable within 5 nm, more preferably within 3 nm of an interface between the Schottky source contact and the oxide semiconductor channel. In this way, saddle points *SP* are reduced and/or removed.

In one example, the oxide semiconductor channel has a thickness $H$ sufficiently small such that a maximum potential of a conduction band minimum (i.e. a saddle point) of the oxide semiconductor channel at zero bias is within 10 nm, preferable within 5 nm, more preferably within 3 nm of an interface between the Schottky source contact and the oxide semiconductor channel. This is particularly the case when the oxide semiconductor channel comprises and/or is formed from IGZO.

In one example, a conduction band of the oxide semiconductor channel at zero bias decreases, for example monotonically, away from an interface between the Schottky source contact and the oxide semiconductor channel. In this way, saddle points *SP* are reduced and/or removed.

*Oxide semiconductor*

It should be understood that the oxide semiconductor channel comprises and/or is formed from the oxide semiconductor and has a sufficiently high conductivity when the transistor is turned on, so that the source contact region of the transistor largely determines the transistor current.

In one example, the oxide semiconductor comprises and/or is an amorphous oxide semiconductor. In one example, the oxide semiconductor comprises and/or is a crystalline oxide semiconductor. In one example, the oxide semiconductor comprises and/or is an n-type oxide semiconductor. In one example, the oxide semiconductor comprises and/or is a p-type oxide semiconductor.

In one example, the oxide semiconductor comprises and/or is a ZnO-based oxide semiconductor, preferably an amorphous ZnO-based oxide semiconductor. In one example, the ZnO-based oxide semiconductor includes at least one selected from the group consisting of hafnium (Hf), yttrium (Y), tantalum (Ta), zirconium (Zr), titanium (Ti), copper (Cu), nickel (Ni), chromium (Cr), indium (In), gallium (Ga), aluminum (Al), tin (Sn), and magnesium (Mg).

In one example, the oxide semiconductor comprises and/or is ZnO, ZnGaO, ZnSnO, $In_2O_3$, InSnO, InZnO, InGaO, InGaZnO, InHfZnO, InSiZnO, InZrZnO, InSnZnO, InGaSnO, $SnO_2$, AlZnO, AlZnSnO and/or ZrZnSnO. In one example, the oxide semiconductor comprises and/or is crystalline, for example polycrystalline, ZnO, crystalline, for example polycrystalline, ZnGaO, crystalline, for example polycrystalline, ZnSnO, crystalline, for example polycrystalline, $In_2O_3$, crystalline, for example polycrystalline, InSnO, crystalline, for example polycrystalline, InZnO, crystalline, for example polycrystalline, InGaO, crystalline, for example polycrystalline, InGaZnO, crystalline, for example polycrystalline, InHfZnO, crystalline, for example polycrystalline, InSiZnO, crystalline, for example polycrystalline, InZrZnO, crystalline, for example polycrystalline, InSnZnO, crystalline, for example polycrystalline, InGaSnO, crystalline, for example polycrystalline, SnOz, crystalline, for example polycrystalline, AlZnO, crystalline, for example polycrystalline, AlZnSnO, and/or crystalline, for example polycrystalline, ZrZnSnO. In one example, the oxide semiconductor comprises and/or is amorphous ZnO, amorphous ZnGaO, amorphous ZnSnO, amorphous $In_2O_3$, amorphous InSnO, amorphous InZnO, amorphous InGaO, amorphous InGaZnO, amorphous InHfZnO, amorphous InSiZnO, amorphous InZrZnO, amorphous In-

SnZnO, amorphous InGaSnO, amorphous SnOz, amorphous AlZnO, amorphous AlZnSnO, and/or amorphous ZrZnSnO.

In one preferred example, the oxide semiconductor is InGaZnO (IGZO). The oxide semiconductor may be $a(In_2O_3).b(Ga_2O_3).c(ZnO)$. More preferably, the oxide semiconductor is amorphous InGaZnO (IGZO). The oxide semiconductor may be amorphous $a(In_2O_3).b(Ga_2O_3).c(ZnO)$. In one example, a, b, and c are real numbers where $a \geq 0$, $b \geq 0$, and/or $c > 0$. In one example, a, b, and c are real numbers where $a \geq 1$, $b \geq 1$, and/or $0 < c \leq 1$. In one example, a = 1, b = 1 and c = 2.

In one example, the oxide semiconductor channel is treated, for example by annealing and/or by plasma treatment, before deposition of the Schottky source contact thereon, as described below in more detail.

In one example, the oxide semiconductor comprises an oxygen-depleted region. In one example, the oxide semiconductor comprises an oxygen-depleted region proximal to and/or at an interface between the oxide semiconductor channel and the Schottky source contact. In one example, the oxygen-depleted region is within 5 nm, preferably within 3 nm of the interface. In one example, the oxygen-depleted region is formed during annealing prior to deposition of the Schottky source contact.

Preferably, the oxide semiconductor is IGZO, more preferably amorphous IGZO

*Oxide semiconductor channel thickness H*

If the oxide semiconductor channel thickness *H* is too large, the height of the saddle point SP and/or the distance of the saddle point from the interface may be too large and hence the effective source barrier height $\Phi_B^e$ too high for the desired Schottky source contact behaviour i.e. voltage independence. Conversely, the inventors have determined, as described below in more detail, that if the oxide semiconductor channel thickness *H* is too small, an electric field in use becomes so large that tunnelling and other barrier lowering mechanisms additionally affect a saturation current of an output curve of the SBTFT.

In one example, the oxide semiconductor channel has a thickness *H* in a range from 5 nm to 50 nm, preferably in a range from 10 nm to 40 nm, more preferably in a range from 15 nm to 30 nm, for example 20 nm or 25 nm. It should be understood that the thickness *H* of the oxide semiconductor channel is measured in a direction orthogonal to a plane of the interface between the oxide semiconductor channel and the Schottky source contact.

*Schottky source contact*

In one example, the Schottky source contact comprises and/or is formed of a material, for example a metal, an alloy, a non-metal, having a work function of at least 4.5 eV, preferably at least 5 eV (Table 1). In one example, the Schottky source contact comprises and/or is formed of Pt, Pd, Ni, Au and/or ITO.

In one example, the Schottky source contact is deposited on the oxide semiconductor channel by by sputtering in an atmosphere comprising oxygen.

In one example, the Schottky source contact has a thickness in a range from 10 nm to 250 nm, preferably in a range from 25 nm to 150 nm, more preferably in a range from 50 nm to 100 nm, for example 70 nm.

Table 1: Work functions (eV) of various elements

| Element | Work function (eV) | Element | Work function (eV) | Element | Work function (eV) |
|---------|--------------------|---------|--------------------|---------|--------------------|
| Ag | 4.26 - 4.74 | Al | 4.06 - 4.26 | As | 3.75 |
| Au | 5.10-5.47 | B | ~4.45 | Ba | 2.52-2.70 |
| Be | 4.98 | Bi | 4.31 | C | ~5 |
| Ca | 2.87 | Cd | 4.08 | Ce | 2.9 |
| Co | 5 | Cr | 4.5 | Cs | 1.95 |
| Cu | 4.53 - 5.10 | Eu | 2.5 | Fe: | 4.67 - 4.81 |
| Ga | 4.32 | Gd | 2.90 | Hf | 3.90 |
| Hg | 4.475 | In | 4.09 | Ir | 5.00 - 5.67 |
| K | 2.29 | La | 3.5 | Li | 2.9 |
| Lu | ~3.3 | Mg | 3.66 | Mn | 4.1 |
| Mo | 4.36 - 4.95 | Na | 2.36 | Nb | 3.95 - 4.87 |

(continued)

| Element | Work function (eV) | Element | Work function (eV) | Element | Work function (eV) |
|---|---|---|---|---|---|
| Nd | 3.2 | Ni | 5.04 - 5.35 | Os | 5.93 |
| Pb | 4.25 | Pd | 5.22-5.60 | Pt | 5.12-5.93 |
| Rb | 2.261 | Re | 4.72 | Rh | 4.98 |
| Ru | 4.71 | Sb | 4.55-4.70 | Sc | 3.5 |
| Se | 5.9 | Si | 4.60 - 4.85 | Sm | 2.7 |
| Sn | 4.42 | Sr | ~2.59 | Ta | 4.00-4.80 |
| Tb | 3.00 | Te | 4.95 | Th | 3.4 |
| Ti | 4.33 | Tl | ~3.84 | U | 3.63-3.90 |
| V | 4.3 | W | 4.32 - 5.22 | Y | 3.1 |
| Yb | 2.60 | Zn | 3.63 - 4.9 | Zr | 4.05 |

In one example, the Schottky source contact comprises a multi-layer Schottky source contact and/or a Schottky source contact having a graded composition. For example, a multi-layer Schottky source contact may comprise a Pt layer, having a thickness of 5 nm, deposited on the oxide semiconductor channel and an Au layer overlaying the Pt layer.

*Interface layer*

In one example, the SBTFT comprises an interface layer arranged between the Schottky source contact and the oxide semiconductor channel. For example, the interface layer may comprise an oxide, for example $AgO_x$, a two-dimensional material, for example graphene or an organic self-assembled monolayer, for example octadecyltrichlorosilane. In one example, the interface layer has a thickness in a range from 0.1 nm to 5 nm, preferably in a range from 0.5 nm to 2 nm.

*Drain contact*

In one example, the drain contact comprises and/or is formed of a material, for example a metal, an alloy, a non-metal, a conductive oxide In one example, the drain contact comprises and/or is formed of a metal such as molybdenum (Mo), copper (Cu), titanium (Ti), aluminum (Al), nickel (Ni), tungsten (W), platinum (Pt), chromium (Cr), gold (Au) or an alloy thereof and/or a conductive oxide such as an indium zinc oxide (IZO), indium tin oxide (ITO), or a mixture thereof.

*Gate contact*

In one example, the gate contact comprises and/or is formed of a material, for example a metal, an alloy, a non-metal, a conductive oxide In one example, the drain contact comprises and/or is formed of a metal such as molybdenum (Mo), copper (Cu), titanium (Ti), aluminum (Al), nickel (Ni), tungsten (W), platinum (Pt), chromium (Cr), gold (Au) or an alloy thereof, a doped semiconductor such as doped silicon (Si), and/or a conductive oxide such as an indium zinc oxide (IZO), indium tin oxide (ITO), or a mixture thereof.

*SBTFT stack*

In one example, the SBTFT comprises a stack formed from a gate insulator layer, the oxide semiconductor channel overlaying the gate insulator layer, the Schottky source contact overlaying at least a first part of the oxide semiconductor channel, a gate contact overlaying at least a second part of the oxide semiconductor channel and a drain contact, wherein the source contact, the gate contact and the drain contact are mutually spaced.

*Preferred example*

In one example, the SBTFT comprises:

a stack formed from a gate insulator layer, wherein the gate insulator layer is $SiO_2$;

the oxide semiconductor channel overlaying the gate insulator layer, wherein the oxide semiconductor channel is annealed amorphous a($In_2O_3$).b($Ga_2O_3$).c(ZnO), wherein a = 1, b = 1 and c = 2, wherein the oxide semiconductor comprises an oxygen-depleted region, formed during annealing prior to deposition of the source contact and wherein a thickness $H$ of the oxide semiconductor channel is in a range from 5 nm to 50 nm, preferably in a range from 10 nm to 40 nm, more preferably in a range from 15 nm to 30 nm, for example 20 nm or 25 nm;

the Schottky source contact overlaying at least a first part of the oxide semiconductor channel, wherein the source contact is platinum formed by sputtering the platinum on the annealed oxide semiconductor in an atmosphere comprising oxygen;

a drain contact overlaying at least a second part of the oxide semiconductor channel, wherein the drain contact is platinum; and

a gate contact underlaying at least a third part of the gate insulator layer, wherein the gate contact is doped silicon; wherein the source contact, the gate contact and the drain contact are mutually spaced.

A preferred example provides a Schottky barrier thin-film transistor, SBTFT, comprising a Schottky source contact on an oxide semiconductor channel, the SBTFT having an intrinsic gain of at least 500, preferably at least 1,000, more preferably at least 2,000, most preferably at least 3,000, wherein the oxide semiconductor channel is amorphous IGZO, specifically a(In2O3).b(Ga2O3).c(ZnO), wherein a = 1, b = 1 and c = 2, and wherein a thickness H of the oxide semiconductor channel is in a range from 5 nm to 50 nm, preferably in a range from 10 nm to 40 nm, more preferably in a range from 15 nm to 30 nm, for example 16 nm to 28 nm such as 20 nm to 25 nm, for instance 20nm or 25nm; and wherein the source contact is a Schottky source contact formed of a material, for example a metal, an alloy, a non-metal, having a work function of at least 4.5, preferably platinum. The SBTFT suitably has a maximum potential of a conduction band minimum of the oxide semiconductor channel at zero bias within 10 nm, preferably within 5 nm, more preferably within 3 nm of an interface between the Schottky source contact and the oxide semiconductor channel.

According to the second aspect that is not claimed, there is provided an inverter, a logic gate, an integrated circuit, an analogue circuit or a display comprising a Schottky barrier thin-film transistor according to the first aspect.

### *Method of forming a Schottky source contact on an oxide semiconductor channel*

According to the third aspect, there is provided a method according to claim 1.

The Schottky source contact, the oxide semiconductor channel and the SBTFT may be according to the first aspect.

#### *Depositing*

According to the invention, depositing the source contact on the oxide semiconductor channel comprises sputtering the source contact on the oxide semiconductor channel at a sputtering power in a range from 0.4 $W/cm^2$ to 3 $W/cm^2$, preferably in a range from 0.6 $W/cm^2$ to 1.7 $W/cm^2$, for example 0.88 $W/cm^2$ or 1.32 $W/cm^2$. These sputtering powers correspond with a sputtering power in a range from 20 W to 150 W, preferably in a range from 30 W to 80 W, for example 40 W or 60W, respectively, for a 3 inch diameter sputtering target, as used herein.

In one example, depositing the source contact on the oxide semiconductor channel comprises sputtering the source contact on the oxide semiconductor channel to a thickness in a range from 10 nm to 250 nm, preferably in a range from 25 nm to 150 nm, more preferably in a range from 50 nm to 100 nm, for example 70 nm, at a sputtering power in a range from 0.4 $W/cm^2$ to 3 $W/cm^2$, preferably in a range from 0.6 $W/cm^2$ to 1.7 $W/cm^2$, for example 0.88 $W/cm^2$ or 1.32 $W/cm^2$.

Since higher sputtering powers may lead to faster source contact deposition rates, less oxygen may be incorporated at an interface formed between the oxide semiconductor channel and the source contact during sputtering. For example, for IGZO oxide semiconductors, more $In^{3+}$ may be reduced when higher sputtering powers are used, leading to a greater density of lower barrier regions (i.e. greater heterogeneity in barrier height) and a higher reverse current. The effect may be saturated at higher powers because a difference in oxygen content is reduced.

#### *Atmosphere*

In one example, the atmosphere comprising the oxygen is an inert gas, preferably argon, comprising the oxygen in a range from 0.1 % to 10 %, preferably in a range from 1 % to 5 %, for example 3% by partial pressure.

In one example, a pressure of the atmosphere is in a range from $1 \times 10^{-5}$ mbar to $1 \times 10^{-1}$ mbar, preferably in a range from $1 \times 10^{-4}$ mbar to $1 \times 10^{-2}$ mbar, for example $5 \times 10^{-3}$ mbar.

In one example, the atmosphere consists essentially of oxygen at a pressure in a range from $1 \times 10^{-8}$ mbar to $1 \times 10^{-2}$ mbar, preferably in a range from $1 \times 10^{-7}$ mbar to $1 \times 10^{-2}$ mbar, more preferably in a range from $1 \times 10^{-6}$

mbar to $1 \times 10^{-3}$ mbar, for example $1 \times 10^{-5}$ mbar or $1 \times 10^{-4}$ mbar.

*Annealing*

In one example, the method comprises treating the oxide semiconductor channel prior to depositing the source contact thereon, to increase a conductivity of the oxide semiconductor channel, improve operation voltage and/or improve carrier mobility. Treating the oxide semiconductor channel may be by annealing (also known as thermal annealing) and/or by plasma treatment, for example argon plasma treatment.

In one example, the method comprises annealing the oxide semiconductor channel prior to depositing the source contact thereon.

In one example, the annealing is in an inert atmosphere, preferably nitrogen, at a temperature in a range from 200 °C to 400 °C, preferably in a range from 250 °C to 350 °C, for example 300 °C for at least 15 minutes, preferably for at least 30 minutes, more preferably for at least 60 minutes. While the annealing may increase a conductivity of the oxide semiconductor channel, improve operation voltage and/or improve carrier mobility, the annealing may also result in surface regions, and/or a through thickness, of the oxide semiconductor channel becoming depleted with respect to oxygen.

*Oxide semiconductor channel*

In one example, the oxide semiconductor channel is provided by sputtering, pulsed laser deposition, solution processing, combustion synthesis and/or spin coating. In one example, the oxide semiconductor channel is provided by sputtering.

*Preferred example*

In one example, the method comprises:

annealing the oxide semiconductor prior to depositing the source contact thereon; and
depositing the source contact on the oxide semiconductor channel in an atmosphere comprising oxygen;
wherein the annealing is in an inert atmosphere, preferably nitrogen, at a temperature in a range from 200 °C to 400 °C, preferably in a range from 250 °C to 350 °C, for example 300 °C for at least 30 minutes, preferably about 60 minutes;
wherein the atmosphere comprising the oxygen is an inert gas, preferably argon, comprising the oxygen in a range from 0.1 % to 10 %, preferably in a range from 1 % to 5 %, for example 3% by partial pressure;
wherein the pressure of the atmosphere is in a range from $1 \times 10^{-5}$ mbar to $1 \times 10^{-1}$ mbar, preferably in a range from $1 \times 10^{-4}$ mbar to $1 \times 10^{-2}$ mbar, for example $5 \times 10^{-3}$ mbar;
wherein the oxide semiconductor channel is amorphous IGZO, preferably a($In_2O_3$).b($Ga_2O_3$).c(ZnO), wherein a = 1, b = 1 and c = 2, and wherein a thickness *H* of the oxide semiconductor channel is in a range from 5 nm to 50 nm, preferably in a range from 10 nm to 40 nm, more preferably in a range from 15 nm to 30 nm, for example 16 nm to 28 nm such as 20 nm to 25 nm, for instance 20nm or 25nm;
and wherein the source contact is platinum.

*Definitions*

Throughout this specification, the term "comprising" or "comprises" means including the component(s) specified but not to the exclusion of the presence of other components. The term "consisting essentially of" or "consists essentially of" means including the components specified but excluding other components except for materials present as impurities, unavoidable materials present as a result of processes used to provide the components, and components added for a purpose other than achieving the technical effect of the invention, such as colourants, and the like.

The term "consisting of" or "consists of" means including the components specified but excluding other components.

Whenever appropriate, depending upon the context, the use of the term "comprises" or "comprising" may also be taken to include the meaning "consists essentially of" or "consisting essentially of", and also may also be taken to include the meaning "consists of" or "consisting of".

The optional features set out herein may be used either individually or in combination with each other where appropriate and particularly in the combinations as set out in the accompanying claims. The optional features for each aspect or exemplary embodiment of the invention, as set out herein are also applicable to all other aspects or exemplary embodiments of the invention, where appropriate. In other words, the skilled person reading this specification should consider the optional features for each aspect or exemplary embodiment of the invention as interchangeable and combinable between different aspects and exemplary embodiments.

**Brief description of the drawings**

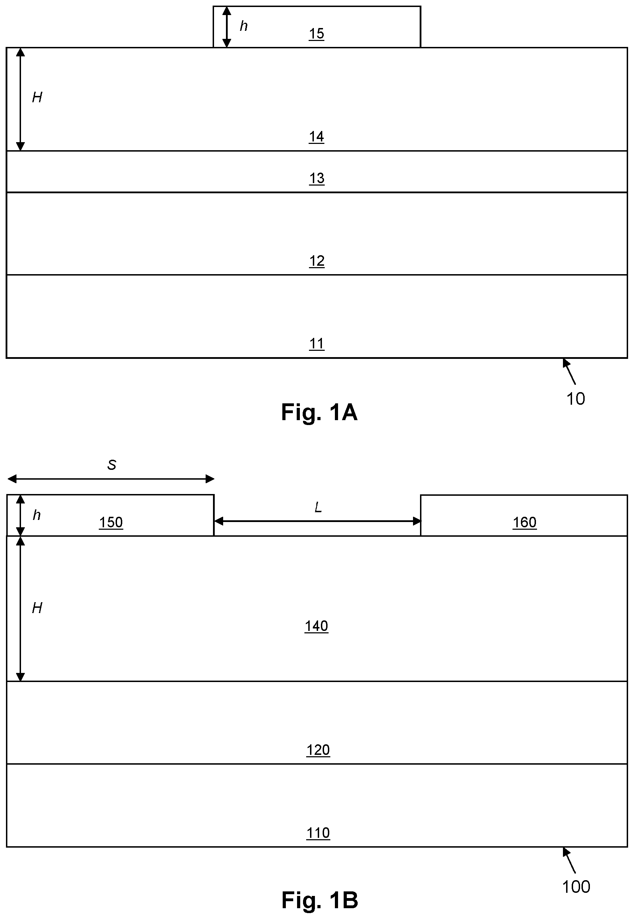

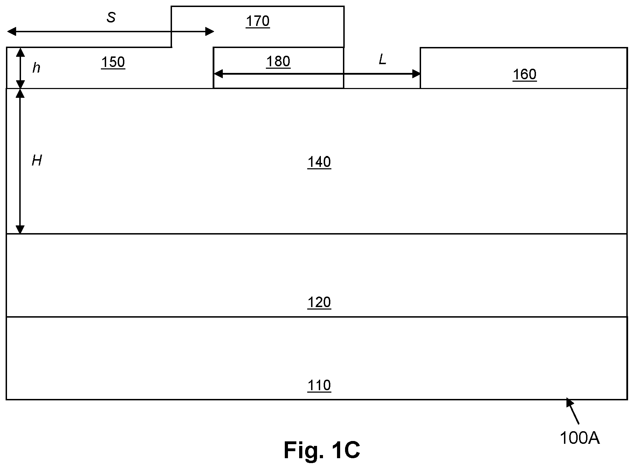

The following examples described with respect to Figures 1, 2 and 7 are not according to the invention and are present for illustration purposes only.

For a better understanding of the invention, and to show how exemplary embodiments of the same may be brought into effect, reference will be made, by way of example only, to the accompanying diagrammatic Figures, in which:

Figure 1A schematically depicts a diode; Figure 1B schematically depicts a Schottky barrier thin-film transistor; and Figure 1C schematically depicts a Schottky barrier thin-film transistor;

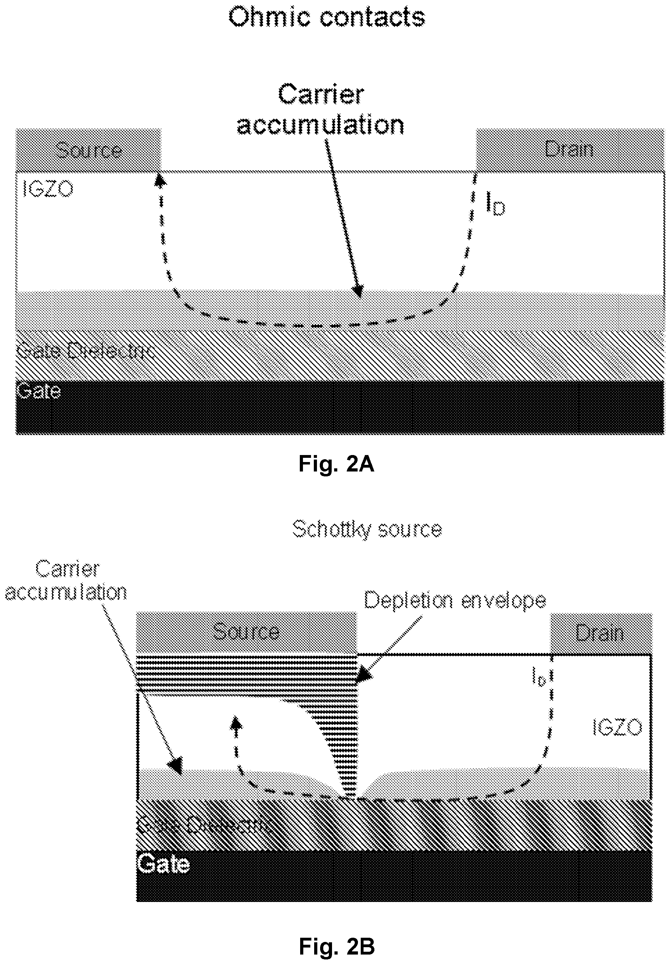

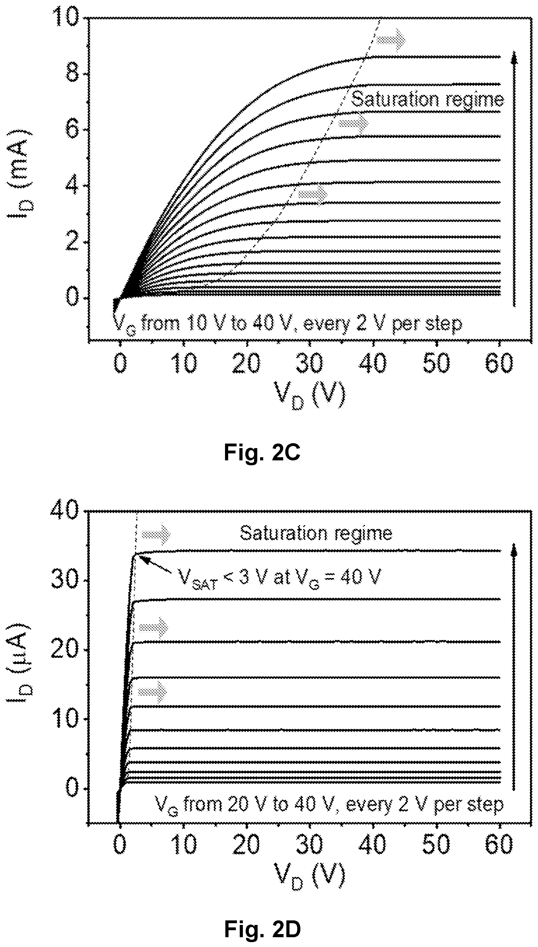

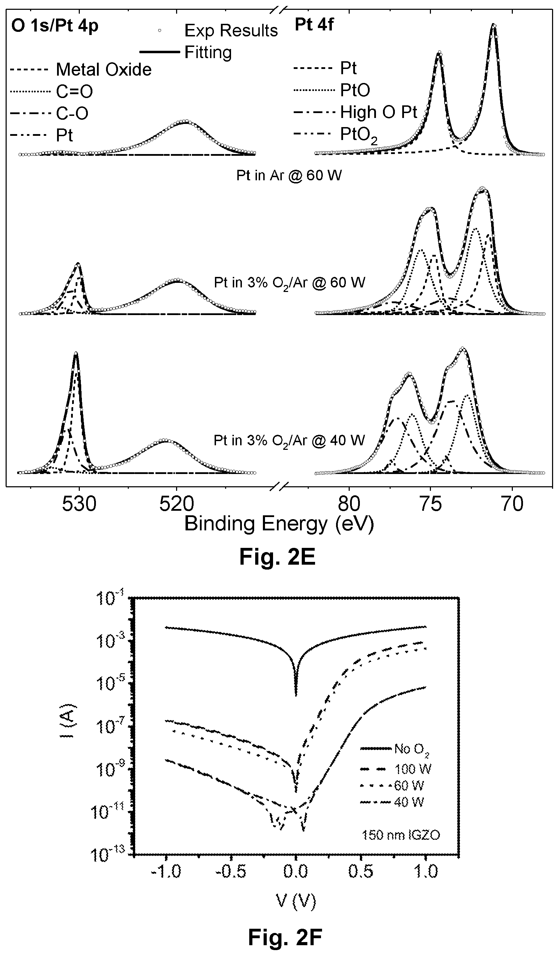

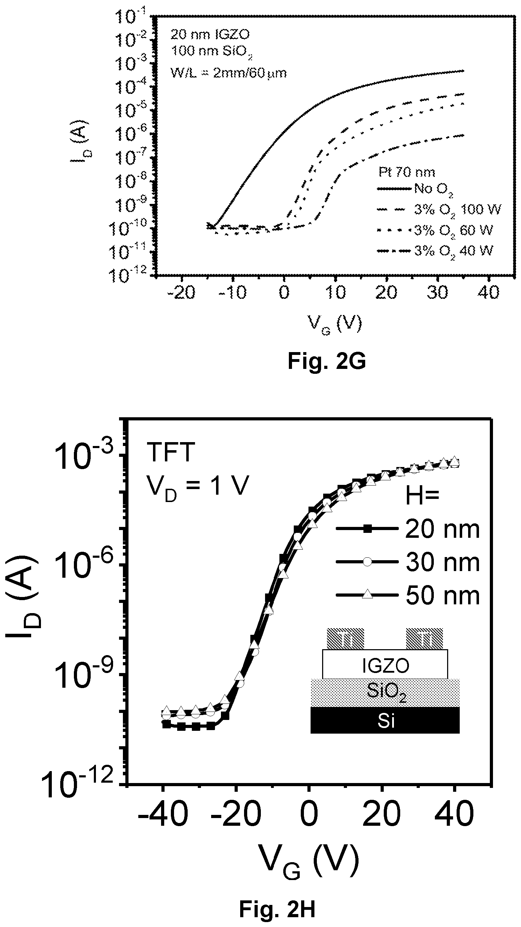

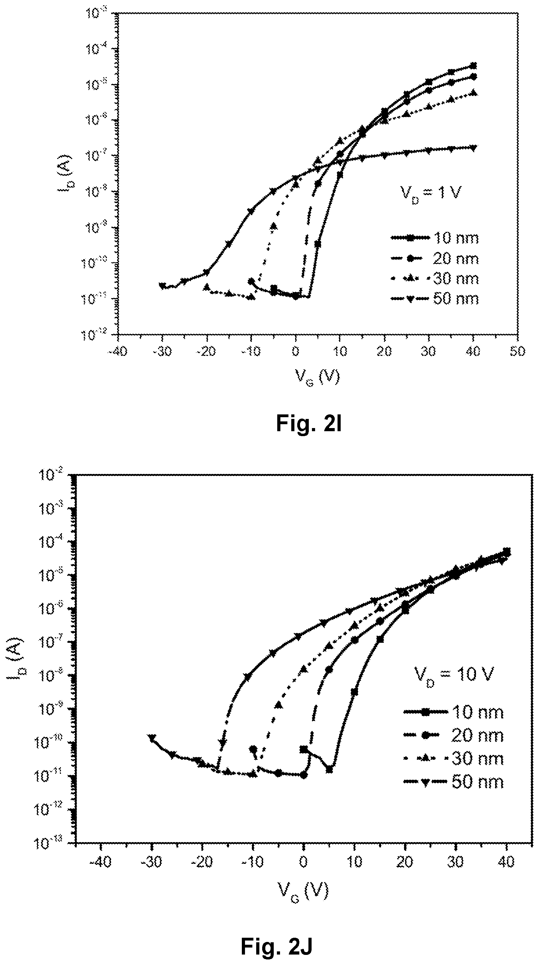

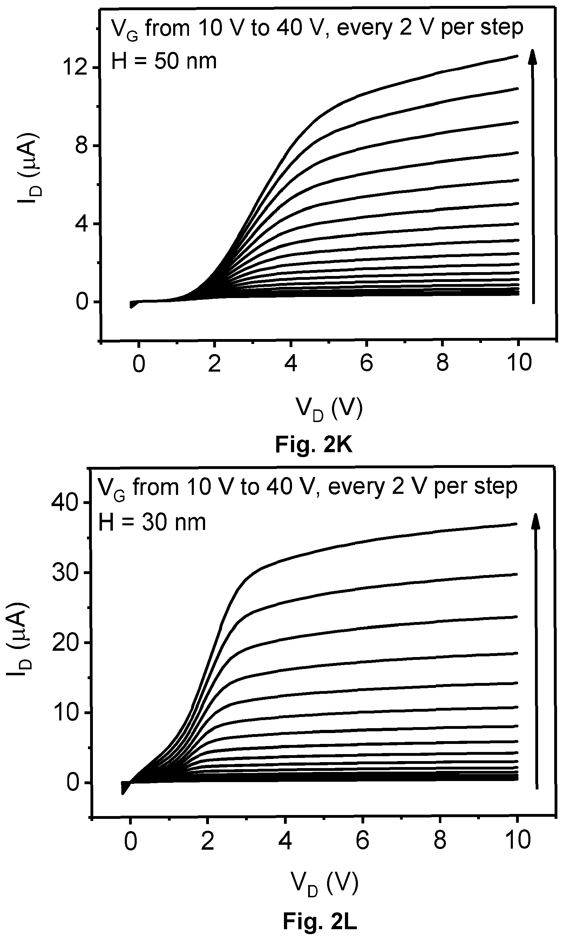

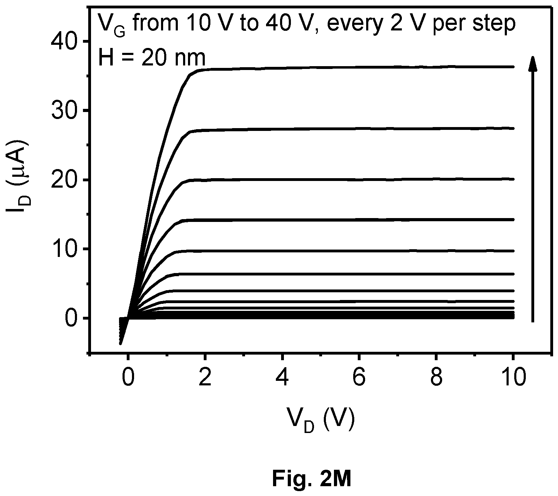

Figures 2A to 2M show designing and optimising Schottky barrier thin-film transistors through tuning source contact deposition conditions and semiconductor thickness, according to exemplary embodiments; Figures 2A schematically depicts structure and conduction path in a TFT with Ohmic contacts (prior art); Figure 2B schematically depicts structure and conduction path in a TFT with Schottky contacts, showing how the current saturates due to depletion under the source; Figure 2C shows typical output curves for a TFT (prior art) and Figure 2D shows typical output curves for a SBTFT: a significant difference (compared with Figure 2C) in saturation voltage occurs because the SBTFT is so easily depleted beneath the source; Figure 2E shows XPS results for Pt films sputtered at 60 W in Ar (top), 60 W in 3% $O_2$/Ar (middle), 40 W in 3% $O_2$/Ar (bottom); Figure 2F shows $|I|$ - $V$ curves for Pt-IGZO Schottky diodes with different powers and oxygen contents during Pt deposition (device structure in inset); Figure 2G shows transfer curves for Pt-IGZO Schottky barrier thin-film transistors with different powers and oxygen contents during Pt deposition (device structure in inset); Figures 2H to 2J show transfer characteristics displaying the thickness dependence of IGZO TFTs (Figure 2H) at $V_D$ = 1 V (device structure in inset), SBTFTs at $V_D$ = 1 V (Figure 2I) and SBTFTs at $V_D$ = 10 V (Figure 2J); Figures 2K to 2M show output characteristics for Schottky barrier thin-film transistors with 50 nm (Figure 2K), 30 nm (Figure 2L) and 20 nm (Figure 2M) IGZO thicknesses respectively;

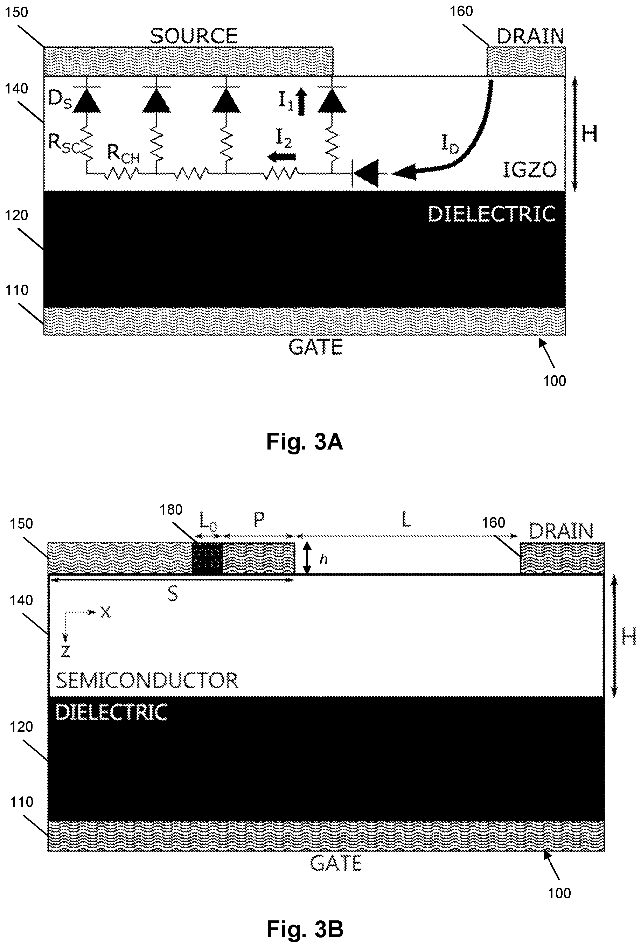

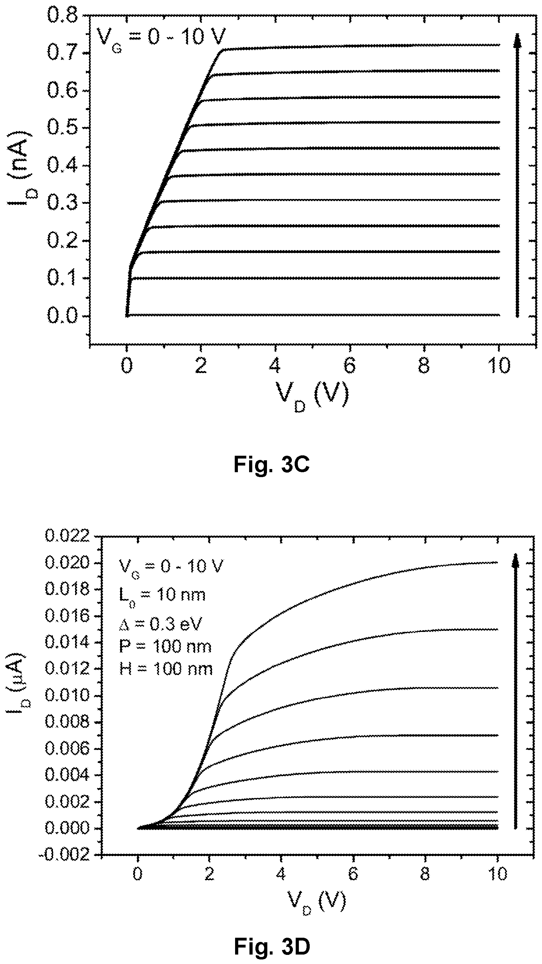

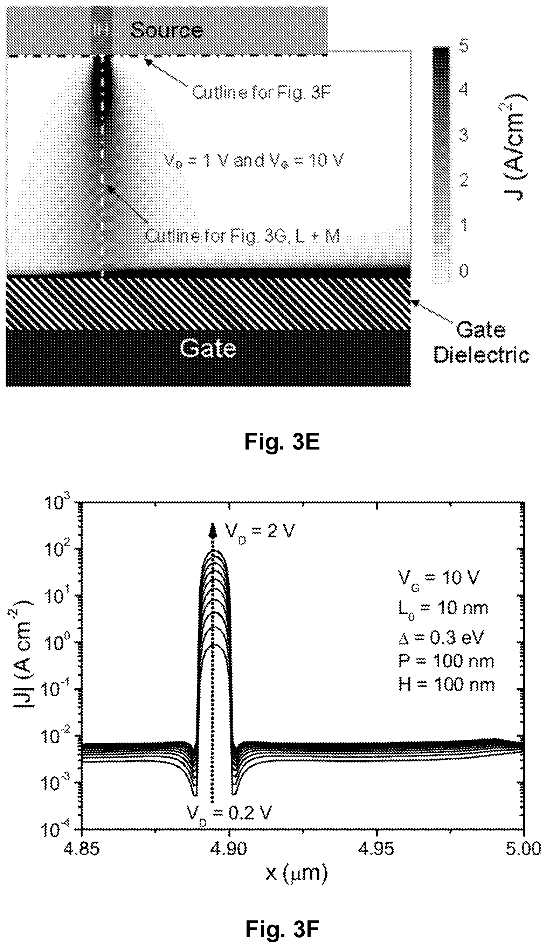

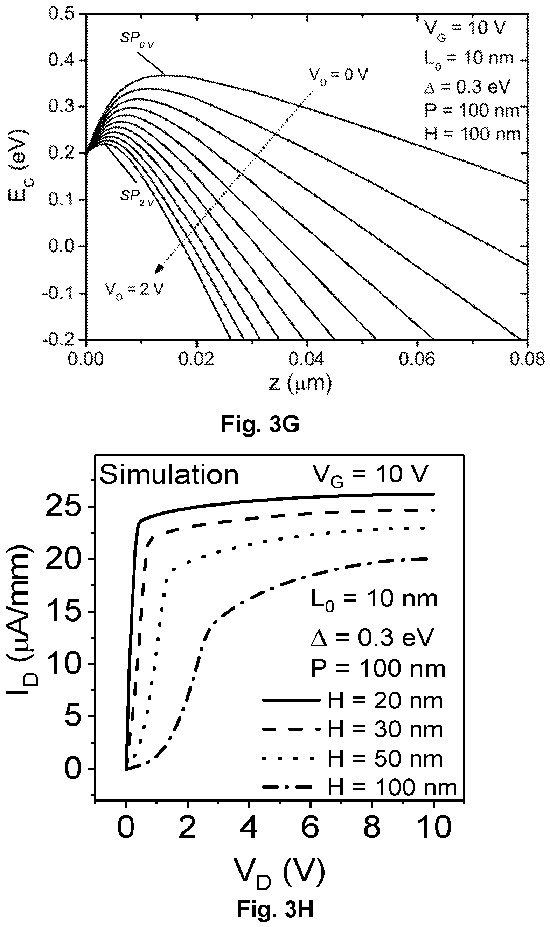

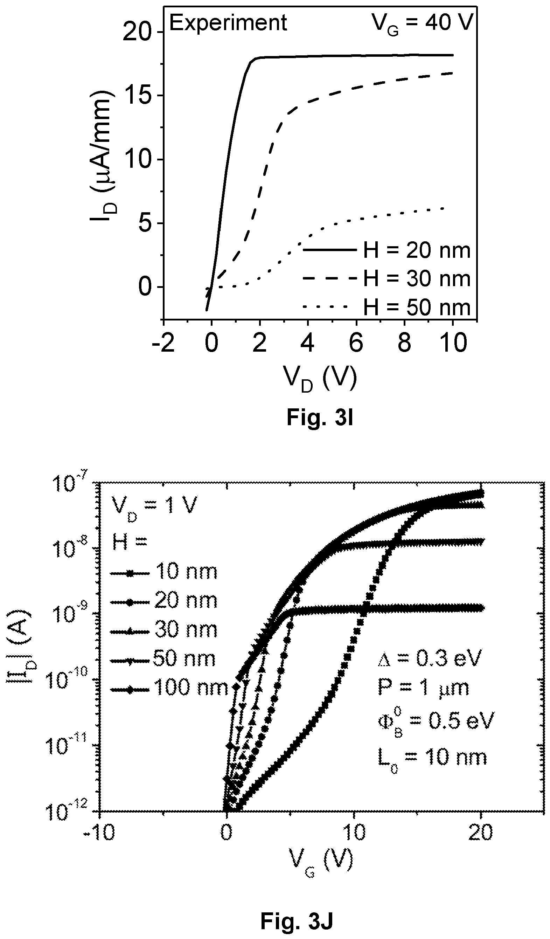

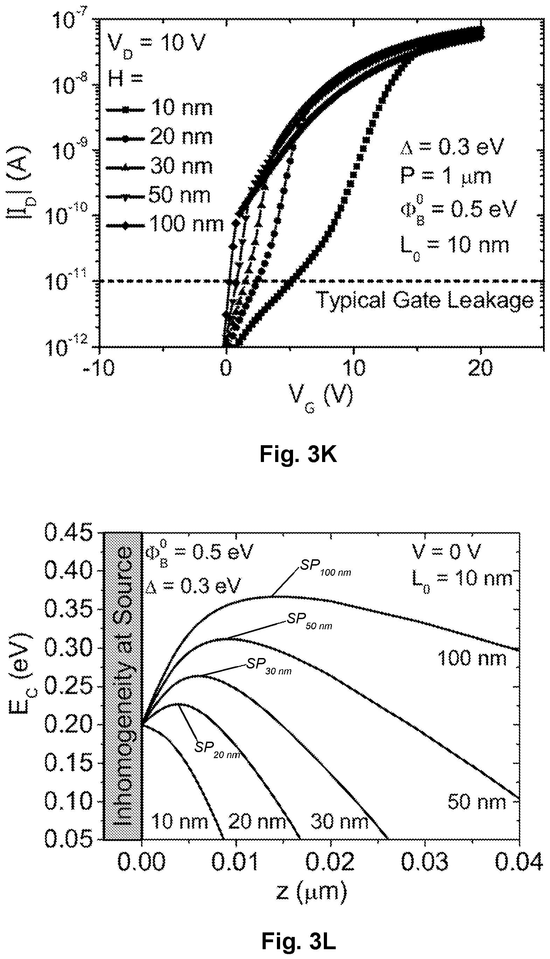

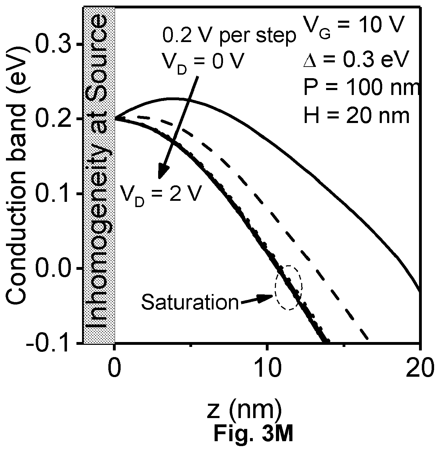

Figure 3A schematically depicts a model of a Schottky barrier thin-film transistor; Figure 3B schematically depicts a model of a Schottky barrier thin-film transistor; Figure 3C schematically depicts $I_D$ - $V_D$ output curves for a Schottky barrier thin-film transistor; Figure 3D schematically depicts $I_D$ - $V_D$ output curves for a Schottky barrier thin-film transistor; Figure 3E shows graphs of current density distribution in the SBTFT of Figure 3D with 100 nm thick IGZO when $V_G$ = 10 V and $V_D$ = 1 V; Figure 3F schematically depicts current densities through the source of the Schottky barrier thin-film transistor in Figure 3D; Figure 3G schematically depicts $E_C$ - $z$ depth profiles of conduction band minima for the Schottky barrier thin-film transistor of Figure 3D; Figures 3H and 3I shows output curves displaying semiconductor thickness dependence of the SBTFT in device simulations (Figure 3H) and experiments (Figure 3I); In Figure 3H, a mean barrier height, $\Phi_B^0$, was 0.5 eV and the barrier height at the inhomogeneity was $\Phi_B = \Phi_B^0 - \Delta$ = 0.2 eV. The inhomogeneity width, $L_0$, was 10 nm and the distance from the source edge, P, was 100 nm; Figures 3J and 3K schematically depicts $|I_D|$ - $V_G$ transfer curves for models of Schottky barrier thin-film transistors according to exemplary embodiments; Figure 3J and Figure 3K show simulated transfer curves for SBTFTs with a barrier inhomogeneity at the source for $V_D$ = 1 V (Figure 3J) and $V_D$ = 10 V (Figure 3K) for IGZO thicknesses of 10, 20, 30, 50 and 100 nm, wherein the inhomogeneity had a magnitude $\Delta$ = 0.3 eV and the inhomogeneity was 1 $\mu$m from the drain end of the source. The results reflect the experimental results shown in Figures 2I and 2J; Similar results can be seen for different values of P and $\Delta$; Figure 3L schematically depicts $E_C$ - $z$ depth profiles of conduction band minima for Schottky barrier thin-film transistors according to exemplary embodiments; and Figure 3M shows profiles of the conduction band minimum beneath the centre of the inhomogeneity of the SBTFT for Figure 3H with 20 nm thick IGZO for $V_D$ = 0 - 2 V;

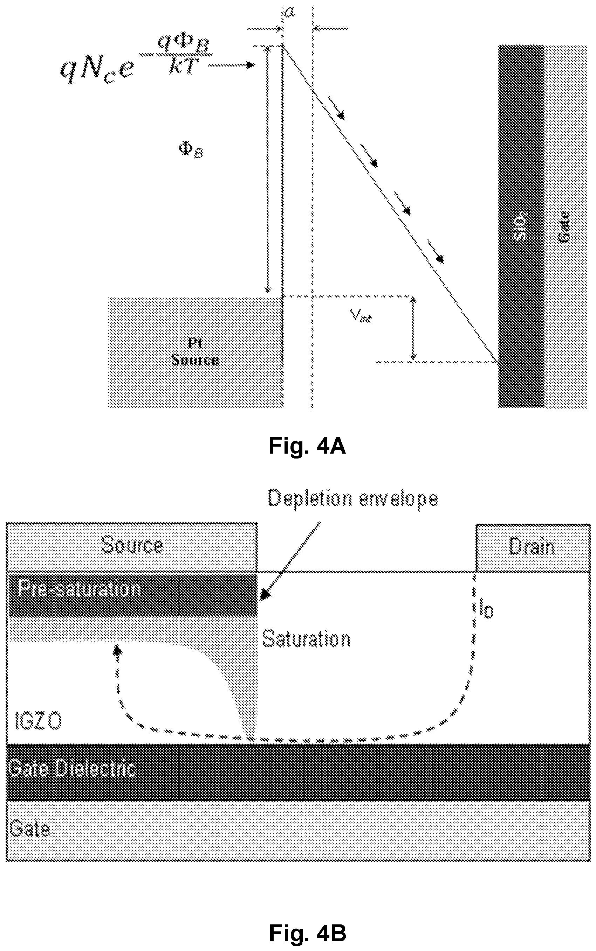

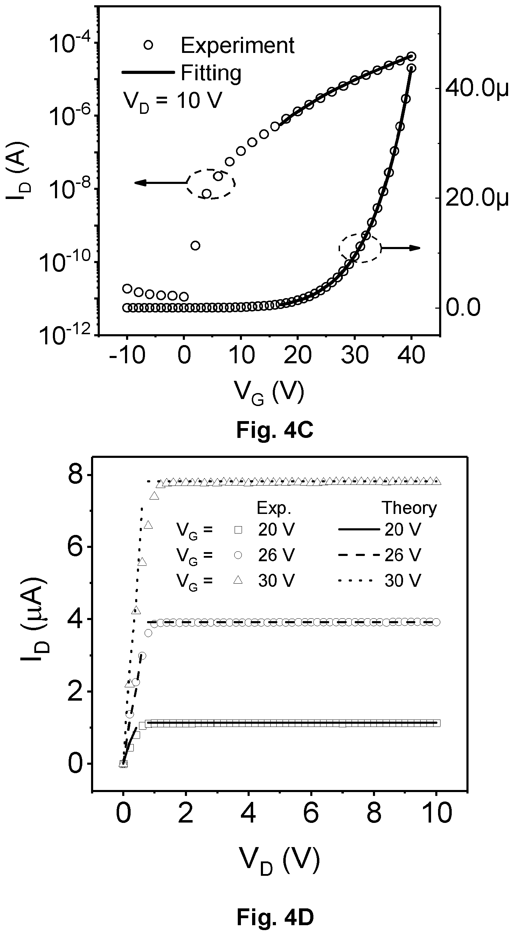

Figures 4A and 4B schematically explain Schottky barrier thin-film transistor theory in the absence of significant barrier inhomogeneities; Figure 4A schematically depicts a conduction band between the source and the semiconductor-dielectric interface showing the mechanism of current injection; and Figure 4B schematically depicts a structure of a Schottky barrier thin-film transistor showing the shape of the depletion region before and after current saturation. Figures 4C and 4D show fitting of the measured transfer curve, when $V_D$ = 10 V (Figure 4C) and the measured output curves, when $V_G$ = 20, 26 and 30 V (Figure 4D);

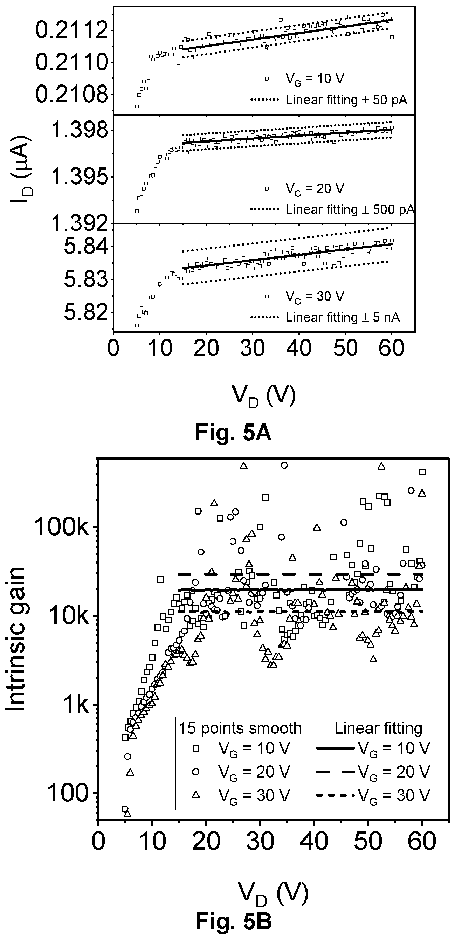

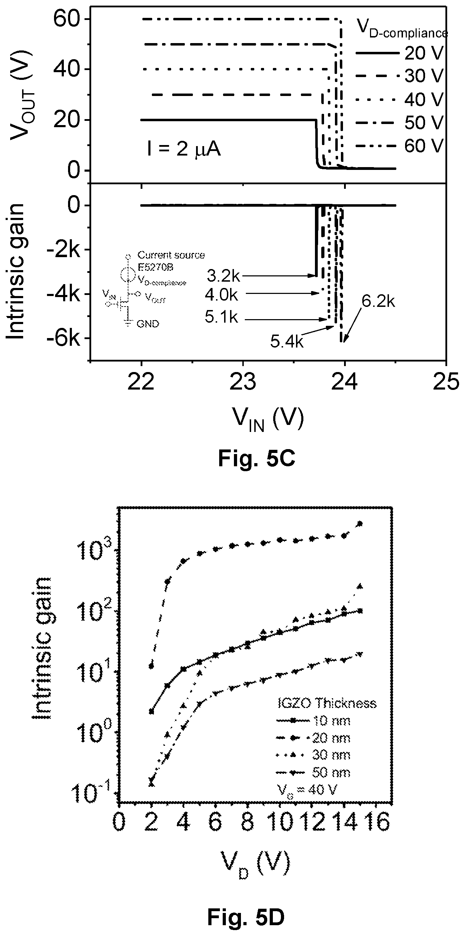

Figures 5A to 5D show intrinsic gain measurements for Schottky barrier thin-film transistors according to exemplary embodiments; Figure 5A shows zoomed output curves of the Schottky barrier thin-film transistors with 20 nm thick IGZO for $V_G$ = 10, 20 and 30 V. A linear fitting of the raw data is taken as the very small fluctuations in current fall within the tolerance of the measurement equipment; Figure 5B shows intrinsic gains of the Schottky barrier thin-film transistors with 20 nm thick IGZO for $V_G$ = 10, 20 and 30 V. The intrinsic gain values obtained by both the linear fitting and a 15 point smoothing of the output curves are displayed; Figure 5C shows intrinsic gains measured using an inverter with a current source (Keysight E5270B) as a load; The measurement set-up is shown in the inset; and Figure 5D schematically depicts intrinsic gains as functions of $V_D$ for a Schottky barrier thin-film transistors with different IGZO thicknesses.

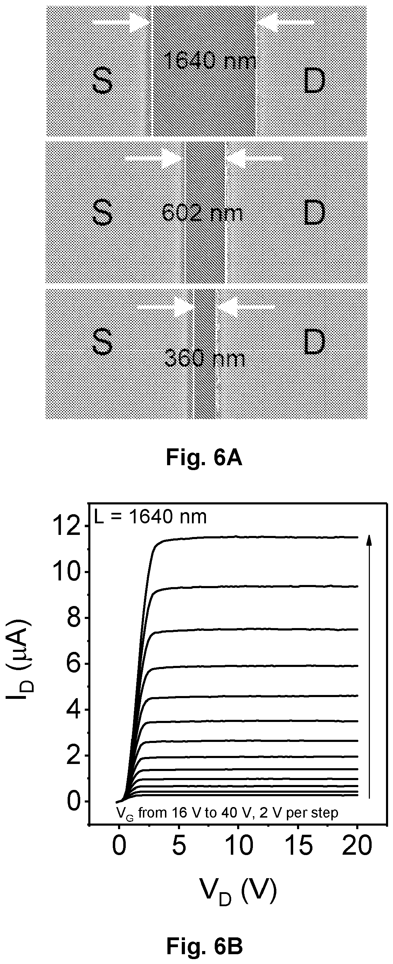

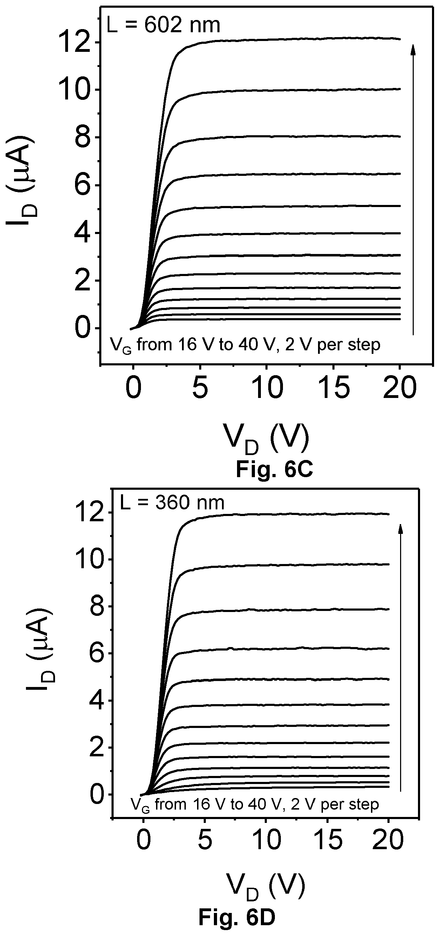

Figures 6A to 6D show advantages of Schottky barrier thin-film transistors for oxide materials; Figure 6A shows scanning electron microscope (SEM) images of channel length of three short-channel SBTFTs; Figures 6B to 6D show output curves for short-channel Schottky contact transistors with channel lengths of 1640 nm (Figure 6B), 602 nm (Figure 6C) and 360 nm (Figure 6D). None of the devices are affected by short-channel effects;

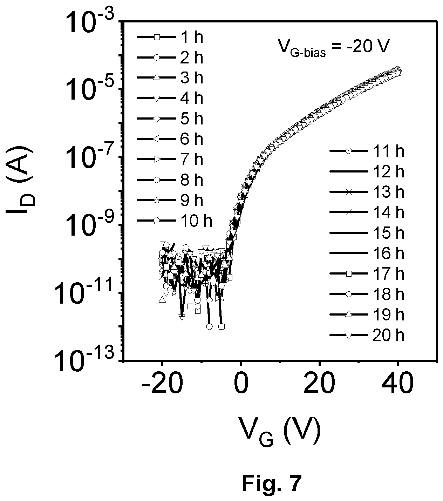

Figure 7 is related to negative bias illumination stress for a Schottky barrier thin-film transistor; Figure 7 shows transfer curves showing that the device behaviour under NBITS for twenty hours. The device was exposed to heating at 60 °C, a 2000 lx white LED and biased at $V_G$ = -20 V;

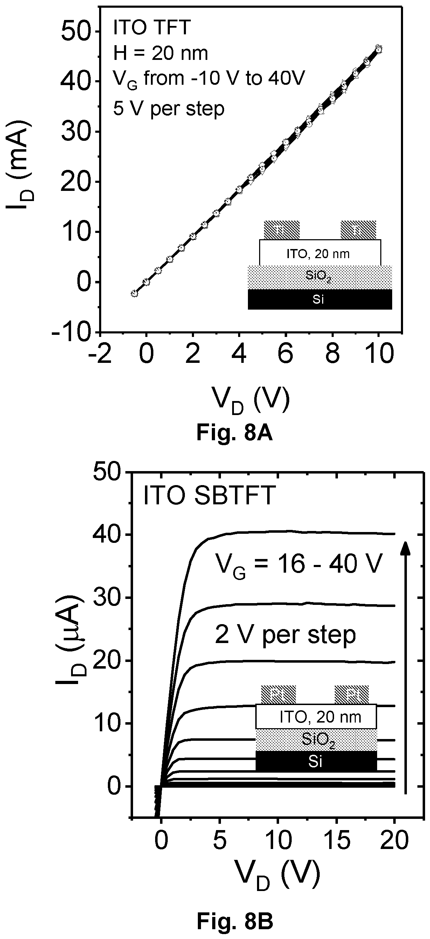

Figure 8A schematically depicts $I_D$ - $V_G$ curves for a TFT with an Ti-ITO channel; and Figure 8B schematically depicts $I_D$ - $V_G$ curves for a SBTFT with an Pt-ITO channel according to an exemplary embodiment;

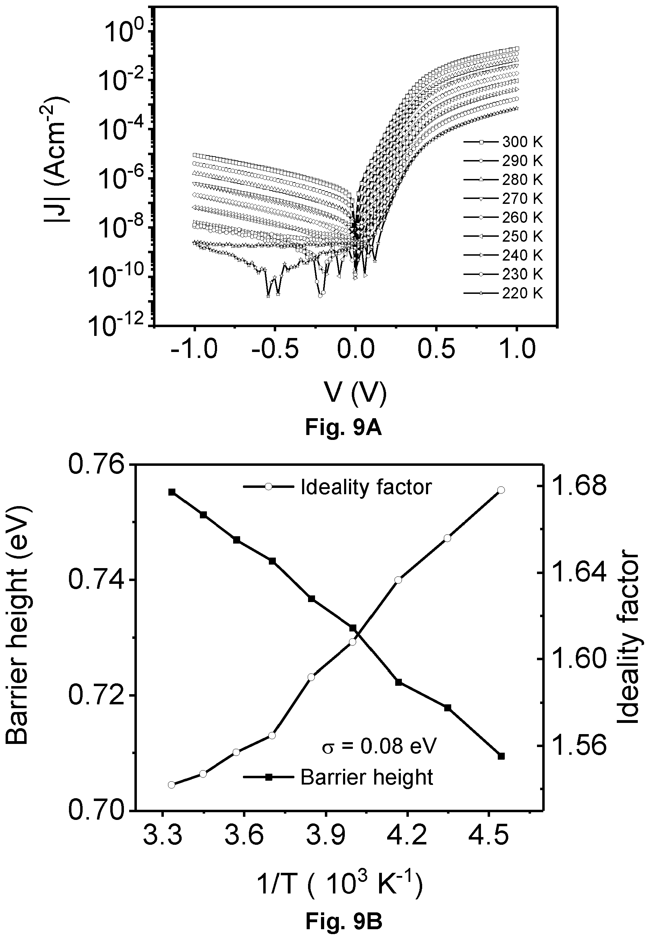

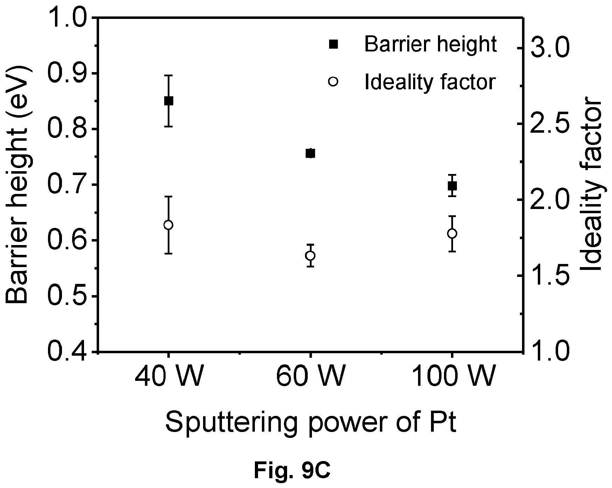

Figure 9A shows |J|-V curves of the Pt-IGZO diodes for different temperatures from 220-300 K wherein Pt was deposited at 60 W in 3% $O_2$/Ar; Figure 9B shows graphs of barrier height and ideality factor against 1/T for the device of Figure 9A, wherein the temperature dependence of the barrier height (standard deviation from the mean barrier height is $\sigma$ = 0.08 eV) indicates the presence of barrier inhomogeneities; and Figure 9C shows graphs of barrier height and ideality factor as a function of Pt deposition power wherein error bars show the standard deviation from the mean;

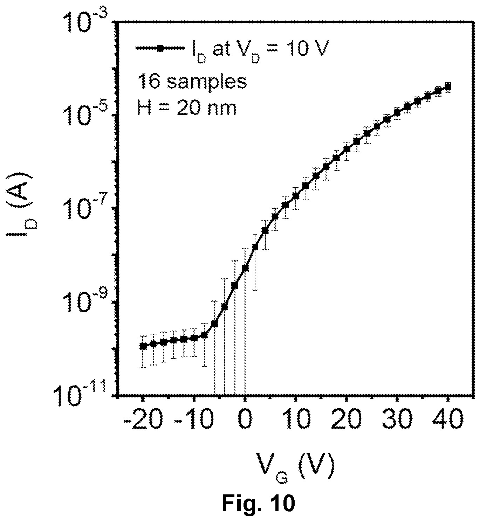

Figure 10 shows a graph of statistical data for 16 SBTFT $I_D$ - $V_G$ transfer curves for an IGZO thickness of 20 nm and Pt deposited at 60 W in 3% $O_2$/Ar (error bars show the standard deviation from the mean);

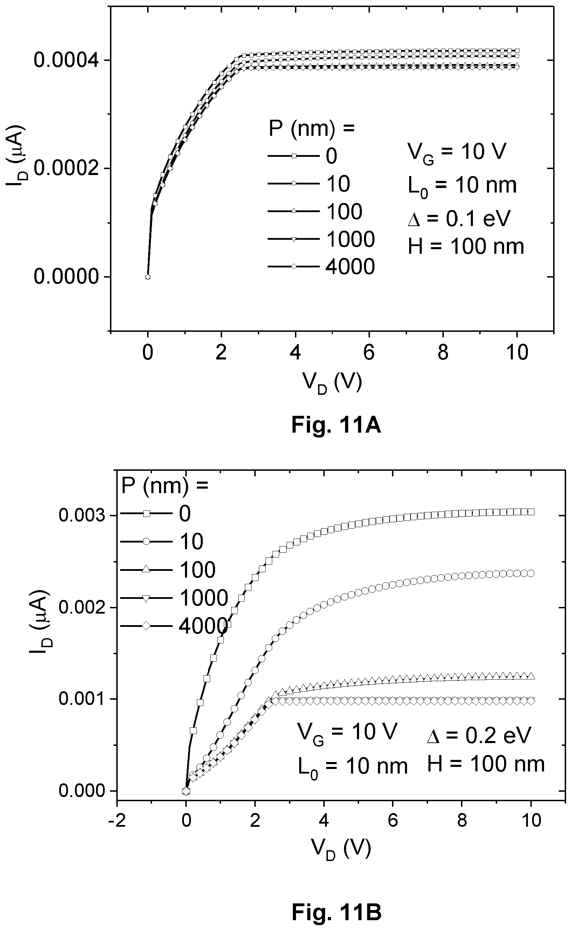

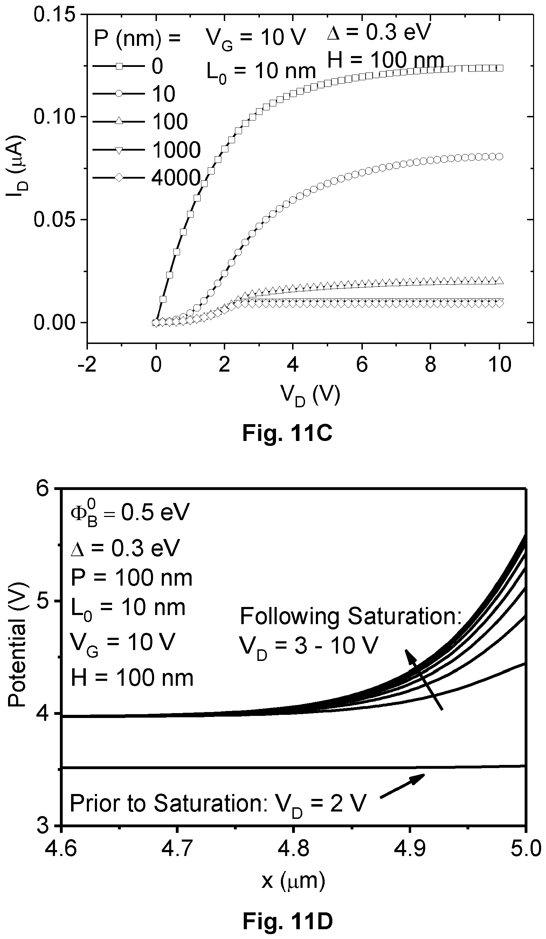

Figures 11A to 11D show the effects of inhomogeneity position upon the characteristics of an SBTFT with a 100 nm thick semiconductor layer, wherein the inhomogeneity is 10 nm wide and $V_G$ = 10 V; Figure 11A: Output curves for $\Delta$ = 0.1 eV; Figure 11B: Output curves for $\Delta$ = 0.2 eV; Figure 11C: Output curves for $\Delta$ = 0.3 eV; Figure 11D: Potential at the semiconductor-dielectric interface for different values of $V_D$ wherein the source edge is at z = 5 $\mu$m;

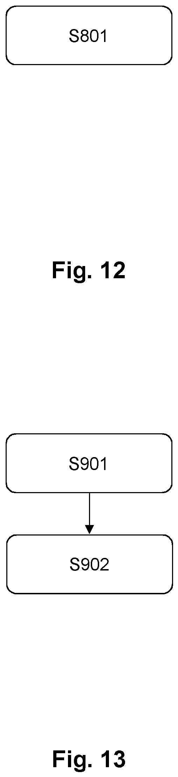

Figure 12 schematically depicts a method of forming a Schottky source contact on an oxide-semiconductor channel according to an exemplary embodiment; and

Figure 13 schematically depicts a method of forming a Schottky source contact on an oxide-semiconductor channel according to an exemplary embodiment.

## Detailed Description of the Drawings

*Control of source barrier*

Figure 1A schematically depicts a diode 10. Particularly, Figure 1A shows a cross-sectional view of a structure of the IGZO - Pt Schottky diode 10 on a Si/SiO$_2$ substrate. The diode 10 comprises a stack formed from a gate contact 11, formed from Si, a dielectric layer 12, formed from SiOz thereupon, an Ohmic contact layer 13, formed from Ti, overlaying the dielectric layer 12, an oxide semiconductor 14, formed from IGZO, overlaying the Ohmic contact layer 13 and a Schottky source contact 15, formed from Pt, overlaying at least a part of the oxide semiconductor 14.

In more detail, the diodes 10 have an oxide semiconductor channel thickness H of 150 nm and the oxide semiconductor is IGZO. The diodes 10 have a Schottky source contact thickness h of 70 nm and the Schottky source contact is Pt (i.e. a metal). The diode 10 has a Ti Ohmic contact having a thickness of 70 nm. All metal layers were deposited via radio-frequency sputtering, as described below. Other materials for the gate contact 11, the dielectric layer 12, the Ohmic contact layer 13 and/or the Schottky source contact 15 are known. Materials for the oxide semiconductor 14 are described herein.

Figure 1B schematically depicts a Schottky barrier thin-film transistor 100. Particularly, Figure 1B shows a cross-sectional view of a structure of the IGZO - Pt SBTFT 100 on a Si/SiO$_2$ substrate. The SBTFT 100 comprises a stack formed from a gate contact 110, formed from Si, a gate insulator layer 120 (also known as a dielectric layer),

formed from $SiO_2$, thereupon, an oxide semiconductor channel 140, formed from IGZO, overlaying the gate insulator layer 120 of the substrate, a Schottky source contact 150, formed from Pt, overlaying a first part of the oxide semiconductor channel 140 and a drain contact 160, formed from Pt, overlaying a second part of the oxide semiconductor channel 140. The Schottky source contact 150 and the drain contact 160 are mutually spaced apart by a length L. The oxide semiconductor channel 140 has a thickness $H$ i.e. an oxide semiconductor channel thickness $H$. The Schottky source contact 150 has a thickness $h$ i.e. a Schottky source contact thickness $h$. In this example, the $Si/SiO_2$ substrate forms the gate contact 110 (also known as a gate electrode) and the gate insulator layer 120. However, it is also possible to form the SBTFT 100 on an insulating substrate such as glass or plastic. In this case, the gate contact 110, for example a metal or a conductive oxide such as ITO, is deposited on the insulating substrate followed by deposition of the gate insulator layer thereon, from $SiO_2$ or $HfO_2$, for example. Other materials for the gate contact 110, the gate insulator layer 120, the Schottky source contact 150, and/or the drain contact 160 are known. Materials for the oxide semiconductor channel 140 are described herein.

In more detail, the SBTFTs 100 have an oxide semiconductor channel thickness $H$ of 20 nm and the oxide semiconductor is IGZO. More generally, the SBTFTs 100 have an oxide semiconductor channel thickness $H$ in a range from 5 nm to 100 nm. The SBTFTs 100 have a source length S of 600 $\mu$m and a channel length $L$ of 60 $\mu$m. The SBTFTs 100 have a width $W$ of 2 mm. The SBTFTs 100 have a Schottky source contact thickness $h$ of 70 nm and the Schottky source contact is Pt (i.e. a metal). All metal layers were deposited via radio-frequency sputtering, as described below.

For SBTFT operation, the IGZO should be highly conductive so that the source region controls the current. This may be achieved through annealing the oxide semiconductor at 300 °C in an $N_2$ atmosphere (i.e. thermal annealing). However, forming a Schottky contact on oxide semiconductors may be highly dependent on the oxygen content at the interface (i.e. the interface between the Schottky source contact and the oxide semiconductor channel). For Pt - IGZO interfaces, this may be attributable to a reduction of $In^{3+}$ to $In^0$. Thus, annealing the oxide semiconductor in the $N_2$ atmosphere can result in poor Schottky barriers, due to removal of $O_2$ from the oxide semiconductor channel.

Figure 1C schematically depicts a Schottky barrier thin-film transistor 100A. Particularly, Figure 1C shows a cross-sectional view of a structure of the IGZO - Pt SBTFT 100 on a $Si/SiO_2$ substrate. The SBTFT 100A is generally as described above with respect to the SBTFT 100.

In contrast to the SBTFT 100, the SBTFT 100A further comprises a field plate 170, formed from Pt, extending from the Schottky source contact 150 and overlaying another dielectric layer 180, formed from $SiO_2$. The dielectric layer 180 overlays a third part of the oxide semiconductor channel 140, between the Schottky source contact 150 and the drain contact 160, thereby partly filling the gap therebetween. The field plate 170 provides capacitive coupling between the Schottky source contact 150 and the oxide semiconductor channel 140, thereby preventing high electric fields proximal and/or an edge of the Schottky source contact 150.

Figures 2A to 2M show designing and optimising Schottky barrier thin-film transistors through tuning source contact deposition conditions and semiconductor thickness, according to exemplary embodiments. Figures 2A schematically depicts structure and conduction path in a TFT with Ohmic contacts (prior art). Figure 2B schematically depicts structure and conduction path in a TFT with Schottky contacts, showing how the current saturates due to depletion under the source. Figure 2C shows typical output curves for a TFT (prior art) and Figure 2D shows typical output curves for a SBTFT: a significant difference (compared with Figure 2C) in saturation voltage occurs because the SBTFT is so easily depleted beneath the source. Figure 2E shows XPS results for Pt films sputtered at 60 W in Ar (top), 60 W in 3% $O_2$/Ar (middle), 40 W in 3% $O_2$/Ar (bottom). Figure 2F shows $|I|$ - $V$ curves for Pt-IGZO Schottky diodes with different powers and oxygen contents during Pt deposition (device structure in inset). Figure 2G shows transfer curves for Pt-IGZO Schottky barrier thin-film transistors with different powers and oxygen contents during Pt deposition (device structure in inset). Figures 2H to 2J show transfer characteristics displaying the thickness dependence of IGZO TFTs (Figure 2H) at VD = 1 V (device structure in inset), SBTFTs at $V_D$ = 1 V (Figure 2I) and SBTFTs at $V_D$ = 10 V (Figure 2J). Figures 2K to 2M show output characteristics for Schottky barrier thin-film transistors with 50 nm (Figure 2K), 30 nm (Figure 2L) and 20 nm (Figure 2M) IGZO thicknesses respectively.

The barrier at the source is the most important feature of the Schottky barrier thin-film transistor. Forming a Schottky source on oxide semiconductors is highly challenging and dependent on a having sufficient oxygen content at the interface. The need for a conductive channel further complicates fabrication as oxygen vacancies are the donor states in oxide semiconductors. Moreover, post-annealing to improve conductivity can damage the barrier, so the annealing required to produce a conductive channel must be carried out before the deposition of the Schottky contact. Thus, to guarantee sufficient oxygen at the interface, oxygen is included during the deposition of the Schottky contact. Sputtering Pt in 3% $O_2$/Ar and controlling the deposition power allowed the inventors to control the oxygen content in the Pt film. X-ray photoelectron spectroscopy (XPS) results in Figure 2E show negligible oxygen content in the Pt film deposited in pure Ar. When oxygen is introduced, the ratio of O 1s to Pt $4p_{3/2}$ peak areas grows and the Pt $4f_{5/2}$ and $4f_{7/2}$ peaks shift to the left, indicating oxidation of the Pt film. The oxygen content is further increased by reducing the sputtering power from 60 to 40 W.

*Schottky barrier thin-film transistors*

A conventional TFT comprises source and drain electrodes which are joined by a semiconductor channel. In order for the TFT to operate, the contacts should be Ohmic, i.e. of low resistance. The channel is capacitively coupled to a gate electrode via an insulating dielectric, and thus the gate voltage, $V_G$, controls the conductivity of the channel (Figure 2A). In Schottky barrier thin-film transistors (Figure 2B) the source contact is replaced by a diode-like Schottky barrier. As such, it is the source rather than the channel that determines the current.

The effect of replacing the Ohmic source with a Schottky source is demonstrated by the output curves of an IGZO TFT and SBTFT in Figure 2C and Figure 2D. The TFT current only saturates at high drain voltages, whereas the saturation at significantly lower voltages in the SBTFT is made possible by the full depletion of the semiconductor layer by the Schottky source (see Figure 2B). More importantly, the better saturation in the SBTFT means that the intrinsic gain, which is a critical figure of merit for transistors, far exceeds that of a TFT.

The suitability of Schottky contacts with different oxygen contents was tested by fabricating Pt-IGZO Schottky diodes and Schottky barrier thin-film transistors. Figure 2F shows the *I - V* curves for the Schottky diodes and Figure 2G shows the SBTFT transfer curves. Without oxygen treatment the Pt-IGZO diode is effectively Ohmic due to the formation of lower barrier regions in the Schottky contact. The lower barrier regions are caused by $In^{3+}$ being reduced to $In^0$ as a result of insufficient oxygen at the interface. Using oxygen rich Pt as a contact lowers the reverse current in the diode and on-current in the SBTFT by making the barrier more homogeneous. The fact that some barrier height inhomogeneities remain is evidenced by the strong bias dependence of the diode reverse current and low temperature measurements (Figure 9A and Figure 9B). Varying the sputtering power also affects the barrier inhomogeneities, as the barrier height extracted from the diode I-V curves falls with increasing sputtering power (Figure 9C). Higher sputtering power leads to a faster Pt deposition rate, and therefore less oxygen is incorporated at the Pt- IGZO interface. As a result, increasing power causes an increase in the on-current and reduction in turn-on voltage of the Schottky barrier thin-film transistors. Although using a deposition power of 100 W gives a slightly higher on-current in the SBTFT, a power of 60 W gives a more consistent barrier height, so it was selected as the optimal condition for Pt deposition. Further information about the effects of deposition conditions on the barrier can be found in Figure 9C.

Figure 2F schematically depicts |*I*| - *V* curves for diodes 10 according to exemplary embodiments. Particularly, Figure 2F shows |*I*| - *V* curves for Schottky diodes 10 at functions of power and $O_2$ content during Pt deposition. The diodes 10 have an oxide semiconductor channel thickness H of 150 nm and the oxide semiconductor is IGZO. The diodes 10 have a Schottky source contact thickness *h* of 70 nm and the Schottky source contact is Pt (i.e. a metal). The diodes 10 have a Ti Ohmic contact having a thickness *h* of 70 nm. The SBTFTs were formed, at least in part, by sputtering the Schottky source contact Pt in an absence of $O_2$ at a power of 60 W and in a 3% $O_2$/Ar atmosphere at respective powers of 40 W, 60 W and 100 W.

As shown in Figure 2F, annealing the oxide semiconductor in an absence of oxygen results in a IGZO-Pt contact that is effectively Ohmic. To increase the oxygen content at the interface (i.e. the interface between the Schottky source contact and the oxide semiconductor channel), without adversely affecting conductivity of the IGZO channel (i.e. the oxide semiconductor channel), the Pt contacts are sputtered in a 3% $O_2$/Ar atmosphere after the thermal annealing. Figure 2F shows the |J |-V characteristics of the oxygen treated diodes. The reverse current of the diodes increases with the sputtering power of Pt. For example, when V = -1 V, the current in the 100 W diode is over two orders of magnitude larger than in the 40 W diode. Increasing the power above 100 W has limited effect on the current.

As shown in Figure 2G, similar results for the diodes 10 are observed in the SBTFT transfer curves for the SBTFTs 100. The on-currents of the SBTFTs 100, which is determined by the reverse biased Schottky source contact, is 6 V higher for the SBTFT in which the respective Pt source contact was sputtered at a power of 40 W in a 3% $O_2$/Ar atmosphere compared with the SBTFT in which the respective Pt source contact was sputtered at a power of 60 W in a 3% $O_2$/Ar atmosphere. That is, sputtering at the power of 60 W in the 3% $O_2$/Ar atmosphere is preferred compared with sputtering at the power of 60 W in the 3% $O_2$/Ar atmosphere since the current is higher and the on-voltage is closer to zero. At sputtering powers greater than 60 W, there is limited improvement in current and on-voltage.

Such a strong dependence of the reverse current may be associated with a presence of barrier height inhomogeneities. Since higher sputtering powers lead to faster Pt deposition rates, less oxygen may be incorporated at the Pt-IGZO interface during sputtering. Hence, more $In^{3+}$ may be reduced when higher sputtering powers are used, leading to a greater density of lower barrier regions and a higher reverse current. The effect is saturated at higher powers because the difference in oxygen content is reduced.

*Thickness dependence of SBTFT behaviour*

Recently, the inventors have shown a dramatic dependence of the reverse current of Schottky diodes upon semiconductor thickness. Thus, by tuning the thickness, it may be possible to optimise the SBTFT operation. To test this hypothesis, TFTs and SBTFTs with 20, 30 and 50 nm thick IGZO layers were fabricated simultaneously (statistical analysis of the transfer curves of the 20 nm SBTFT is in Figure 10). All the TFTs had a mobility of approximately 7 cm$^2$ V$^{-1}$s$^{-1}$ and $V_T$ of approximately 2 V. As expected, the TFTs showed no discernible thickness dependence (Figure 2H). By contrast, the SBTFT transfer curves in Figure 2I and Figure 2J show two strong thickness dependencies.

Firstly, when the drain voltage, $V_D$, is 10 V, the turn-on voltage, $V_{ON}$, increases from -18 V in the 50 nm case to 0 V in the 20 nm case. The modulation of $V_{ON}$ can be attributed to the ease of channel depletion by the Schottky source; thinner semiconductors are more easily depleted, and hence require a more positive $V_G$ to turn the channel on. Secondly, seemingly counter intuitively, thinner devices in Figure 2I have a greater on-current, which is not explained by the current literature.

Two more trends that cannot be explained with existing understandings are present in output curves in Figures 2K, 2L and 2M. Firstly, a thinner semiconductor gives more linear curves at low $V_D$. Secondly, and critically, in the saturation region where the device is operated, a thinner semiconductor gives a flatter, and therefore more desirable, saturation. The flatness of saturation current is particularly important for achieving high intrinsic gain. Strikingly and somewhat surprisingly, an increase in gain of nearly two orders of magnitude is observed when the IGZO thickness is reduced from 50 to 20 nm. To investigate the origins of this sensitive thickness dependence, device simulations were carried out, as described below.

Fully-depleted inhomogeneous diodes may have a thickness dependent effective barrier height. By tuning (for example optimising) the oxide semiconductor channel thickness H of the SBTFTs 100, the effective barrier height for SBTFT operation may be optimised.

TFTs and SBTFTs 100 with oxide semiconductor channel thicknesses $H$ of 10 nm, 20 nm, 30 nm and 50 nm were fabricated using IGZO as the oxide semiconductor. The TFTs had Ti source-drain contacts deposited in Ar. The SBTFTs 100 had Pt Schottky source contacts 150 deposited by sputtering in an atmosphere of 3% $O_2$/Ar at a power of 60 W.

From the $I_D$ - $V_D$ output curves for the SBTFTs 100 of Figures 2K, 2L and 2M, the saturation voltage decreases as the oxide semiconductor channel thickness $H$ decreases. This is consistent with a two-dielectric model in which:

$$V_{Dsat1} = \frac{C_G(V_G - V_T)}{C_S + C_G}$$

where $V_{Dsat1}$ is the voltage required to fully deplete the oxide semiconductor channel 140 under the Schottky source contact 150 edge (also known as the source saturation voltage), $V_T$ is the threshold voltage of the SBTFT, and $C_S$ and $C_G$ are the capacitances per unit area of the oxide semiconductor channel 140 and the gate insulator 120, respectively. Typically, V$_{Dsat1}$ is much lower than the drain saturation $V_{Dsat2}$ for conventional TFTs, in which:

$$V_{Dsat2} = V_G - V_T$$

Two unexpected trends are also shown.

Firstly, flatter saturation for SBTFTs 100 having smaller oxide semiconductor channel thicknesses H, for example 30 nm and 50 nm.

Secondly, more linear $I_D$ - $V_D$ output curves prior to saturation for SBTFTs 100 having smaller oxide semiconductor channel thicknesses $H$, for example 30 nm and 50 nm. The $V_D$ dependence of saturation current is particularly important for achieving high intrinsic gain, as described below in more detail.

*Effects of barrier inhomogeneities*

A behaviour of SBTFTs may be described using a distributed network of diodes and resistors in a depletion region or envelope of the Schottky source contact 150.

Figure 3A schematically depicts a model of a Schottky barrier thin-film transistor 100. Particularly, Figure 3A shows a cross-sectional view of a distributed diode model of the SBTFT 100.

As described above with respect to Figure 1B, the SBTFT 100 comprises the stack formed from gate contact 110, formed from Si, and the gate insulator layer 120, formed from SiO$_2$, thereupon, the oxide semiconductor channel 140, formed from IGZO, overlaying the gate insulator layer 120 of the substrate, the Schottky source contact 150 overlaying a first part of the oxide semiconductor channel 140 and the drain contact 160, overlaying a second part of the oxide semiconductor channel 140. The SBTFT 100 comprises a gate contact 170 arranged on a reverse side of the Si layer 110 of the substrate. The Schottky source contact 150 and the drain contact 160 are mutually spaced apart by a length L. The oxide semiconductor channel 140 has a thickness $H$ i.e. an oxide semiconductor channel thickness $H$. The Schottky source contact 150 has a thickness $h$ i.e. a Schottky source contact thickness $h$.

The oxide semiconductor channel 140 may be modelled as a distributed network of a plurality of diodes $D_S$ (four diodes arranged mutually in parallel and in series with a fifth diode in this example) and a plurality of resistors $R_{SC}$ (4 in this example) and $R_{CH}$ (3 in this example) arranged there between in a depletion region or envelope of the Schottky source contact 150, in which the resistor $R_{SC}$ is a resistance due, at least in part, to the oxide semiconductor and the resistor $R_{CH}$ is a resistance due, at least in part, to the channel. In use, a drain current $I_D$ is controlled by a reverse biased source barrier. In Mode 1, a current $I_1$ is controlled by modulation of the barrier height at the edge of the Schottky source contact 150 closest to the drain contact 160. In Mode 2, a current $I_2$ is controlled by a restrictive action of a JFET-like depletion region which forms under the edge of the Schottky source contact 150. The drain current $I_D = I_1 + I_2$. That is, the reversed bias diode controls the drain current.

Since the oxide semiconductor channel 140 is highly conductive, vertical transport is likely to be dominated by a reverse bias diode at the Schottky source contact 150 rather than a vertical resistance. An exponential current increase in a reverse bias diode may be attributable to several causes, including tunnelling, image force lowering and/or barrier inhomogeneities. However, if tunnelling or image force lowering were the origin of the exponential current increase, then as the oxide semiconductor channel thicknesses $H$ is reduced, the electric field is increased and hence the exponential dependence of $I_D$ on $V_D$ would only be exacerbated by reducing the oxide semiconductor channel thicknesses $H$. As the experimental results from Figures 2K to 2M show, reducing the oxide semiconductor channel thicknesses $H$ can remove the exponential behaviour and hence tunnelling and/or image force lowering may be discounted and/or negligible and/or not dominate. A dependence of the reverse current on the oxide semiconductor channel thicknesses $H$ in the Pt - IGZO Schottky diodes 10 may be due to barrier height inhomogeneities. However, the presence of inhomogeneities in Schottky source contacts in SBTFTs has until now not been investigated.

Figure 3B schematically depicts a structure of a model of a Schottky barrier thin-film transistor. Particularly, Figure 3B shows a cross-sectional view of a model of the SBTFT containing an inhomogeneity 180 (also known as a barrier inhomogeneity or a lower barrier region) in the source barrier height in the Schottky source contact 150.

As described above with respect to Figure 1B and Figure 3A, the SBTFT 100 comprises the stack formed from the gate contact 110, formed from Si, and the gate insulator layer 120, formed from $SiO_2$, thereupon, the oxide semiconductor channel 140, formed from IGZO, overlaying the gate insulator layer 120 of the substrate, the Schottky source contact 150 overlaying at least a part of the oxide semiconductor channel 140 and the drain contact 160, overlaying at least a part of the oxide semiconductor channel 140. The SBTFT 100 comprises the gate contact 170 arranged on a reverse side of the Si layer 110 of the substrate. The Schottky source contact 150 and the drain contact 160 are mutually spaced apart by a length $L$. The oxide semiconductor channel 140 has a thickness $H$ i.e. an oxide semiconductor channel thickness $H$. The Schottky source contact 150 has a thickness $h$ i.e. a Schottky source contact thickness $h$ and a length $S$ i.e. a Schottky source contact length $S$. The barrier inhomogeneity 180 has a width $L_0$ of 10 nm providing a lower barrier region (LBR) is at a distance P from a drain contact end of the Schottky source contact 150.

In more detail, the SBTFTs 100 were simulated using Silvaco Atlas (RTM) available from Silvaco, Inc. (USA). A barrier inhomogeneity 180 was inserted into the Schottky source contact 150, as shown in Figure 3B. Only inhomogeneities having a barrier height lower than a mean barrier height $\Phi_B^0$ of 0.5 eV were considered, as higher barriers are not expected to contribute significantly to the drain current $I_D$. To help understand the different contributions of the randomly distributed inhomogeneities that occur in fabricated Schottky source contacts 150, positions and magnitudes of the inhomogeneity 180 were varied. The Schottky source contact length $S$ was fixed at 5 $\mu$m. The Schottky source contact 150 and the drain contact 160 are mutually spaced apart by a fixed length $L$ (also known as a channel length) of 2 $\mu$m. The barrier inhomogeneity 180 has a width $L_0$ of 10 nm. The channel width was fixed at 1 $\mu$m.

Schottky barrier thin-film transistors were simulated in Silvaco Atlas with a barrier inhomogeneity (IH) inserted into the Schottky source contact, as shown in Figure 3B. Figure 3C schematically depicts $I_D$-$V_D$ output curves for a Schottky barrier thin-film transistor 100. Particularly, Figure 3C shows $I_D$ - $V_D$ output curves for the SBTFT 100 having a homogeneous source barrier for different $V_G$ from 0 V to 10 V in 1 V steps.

In more detail, Figure 3C shows simulated output curves $I_D$ - $V_D$ of the SBTFT 100 having a homogeneous Schottky source contact 150, an oxide semiconductor channel thickness $H$ of 100 nm and wherein the oxide semiconductor is IGZO. Note that such a homogeneous Schottky source contact 150 may not be fabricated in practice and is for comparative purposes. The output curve is typical of a standard SBTFT, with a low saturation current $I_{Dsat}$ of 0.7 nA, a low saturation voltage $V_{Dsat1}$ of 2.6 V and a high output impedance $r_0$ of 200 G$\Omega$, when $V_G$ is 10 V.

Figure 3D schematically depicts $I_D$ - $V_D$ output curves for a Schottky barrier thin-film transistor 100. Particularly, Figure 3D shows simulated $I_D$ - $V_D$ output curves for the SBTFT 100 for different gate contact voltages $V_G$ from 0 V to 10 V in 1 V steps. The SBTFT 100 has an oxide semiconductor channel thickness H of 100 nm and the oxide semiconductor is IGZO. The barrier inhomogeneity has a width $L_0$ of 10 nm and a magnitude $\Delta$ = 0.3 eV. A lower barrier region (LBR) is at a distance $P$ of 100 nm from a drain contact end of the Schottky source contact 150.

In comparison with Figure 3C, Figure 3D shows $I_D$ - $V_D$ output curves for the otherwise same SBTFT as Figure 3C but having an inhomogeneous Schottky source contact 150. In this example, the lower barrier region (LBR) is introduced at the distance $P$ of 100 nm from a drain contact end of the Schottky source contact 150. The barrier in this region is lowered by $\Delta$ = 0.3 eV. The presence of the LBR leads to a large deterioration in output impedance and a current increase larger than one order of magnitude. The non-linear region seen in experiments is also replicated, suggesting that inhomogeneities may be the source of the sub-optimal characteristics seen in Figure 2D and Figure 2E. Similar behaviour may also be seen with different values of $\Delta$, distance $P$ and width $L_0$. $I_D$ - $V_D$ output curves for different gate contact voltages $V_G$ overlap prior to saturation due to the Schottky source being only 5 $\mu$m long in the device simulation. Restrictions upon the number of nodes used in the device simulation prevents simultaneously having a significantly longer source and capturing the fine detail in the region of the barrier inhomogeneity.

The current distribution in Figure 3E shows that the current is dominated by the contribution from the lower-barrier inhomogeneity.

Figure 3E schematically depicts current densities for the Schottky barrier thin-film transistor 100 of Figure 3D. Particularly, Figure 3E shows profiles of current densities |$J$| across the Schottky source contact 150 of the SBTFT 100 of Figure 3D for different gate contact voltages $V_G$ from 0.2 V to 2 V in 0.2 V steps. The SBTFT 100 has an oxide semiconductor channel thickness $H$ of 20 nm and the oxide semiconductor is IGZO. The barrier inhomogeneity 180 has a width $L_0$ of 10 nm and a magnitude $\Delta$ = 0.3 eV. A lower barrier region (LBR) is at a distance P of 100 nm from a drain contact end of the Schottky source contact 150.

In more detail, to establish the origin of the non-linear behaviour shown in Figure 3D, profiles of the current density across the Schottky source contact 150 were taken for drain voltages $V_D$ below saturation. Figure 3E shows that the current density |$J$| is dominated by the contribution from the inhomogeneity 180. Unlike the current density |$J$| contribution from the rest of the Schottky source contact 150, this current density |$J$| increases exponentially, by two orders of magnitude, as the drain voltage $V_D$ increases from 0.2 V to 2 V.

Figure 3F shows profiles of the current density along the Schottky interface were taken for an IGZO thickness, H, of 100 nm. Unlike the rest of the source, the current through the inhomogeneity increases exponentially, by two orders of magnitude, as $V_D$ increases from 0.2 to 2 V. The origin of the exponential growth is elucidated in Figure 3G, which shows the strong voltage dependence of the saddle point, amounting to a voltage dependent effective barrier height. When H = 20 nm, as in Figure 3M, the saddle point is much lower at zero bias and more importantly it has a much weaker bias dependence; hence there is no exponential $I_D$-$V_D$ relation at low $V_D$. Once saturated, it is the absence of a saddle point that enables much flatter current saturation and therefore the striking 2 orders of magnitude increase in gain.

Figure 3G schematically depicts $E_C$ - $z$ depth profiles of conduction band minima for the Schottky barrier thin-film transistor of Figure 3D. That is, Figure 3G schematically depicts conduction band $E_C$ minima as a function of depth $z$. Particularly, Figure 3G shows $E_C$ - $z$ depth profiles of the conduction band minima beneath a centre of the inhomogeneity for different $V_D$ from 0 V to 2 V in 0.2 V steps for a $V_G$ of 10 V. The SBTFT has an oxide semiconductor channel thickness $H$ of 100 nm and the oxide semiconductor is IGZO. The barrier inhomogeneity has a width $L_0$ of 10 nm and a magnitude $\Delta$ = 0.3 eV. A lower barrier region (LBR) is at a distance $P$ of 100 nm from a drain contact end of the Schottky source contact 150. The $E_C$ - $z$ depth profiles have respective saddle points $SP$ ($SP_{0\,V}$ - $SP_{2\,V}$) (i.e. maxima). Only saddle points $SP_{0\,V}$ and $SP_{2\,V}$ are labelled, for clarity.

In more detail, an origin of the exponential growth of the current density |$J$|, described above with respect to Figure 3F, may be understood from Figure 3G. Particularly, Figure 3G shows profiles of the conduction band minima vertically from the centre of the inhomogeneity 180 down to the semiconductor - dielectric interface i.e. as a function of depth $z$. These profiles show that respective saddle points SP are established beneath the inhomogeneity due to pinch-off by the surrounding higher barrier regions. These respective saddle points $SP$ act as effective barrier heights for the inhomogeneity and thus the entire Schottky source contact 150. The strong voltage dependence of the respective saddle points $SP$ leads to the exponential dependence of the current prior to saturation.

The thickness dependencies seen in the experiments are clearly replicated by the simulations as depicted in the output curves in Figures 3H and 3I and the transfer curves in Figures 3J and 3K.

Figure 3J schematically depicts |$I_D$| - $V_G$ transfer curves for models of Schottky barrier thin-film transistors according to exemplary embodiments. Particularly, Figure 3J shows simulated |$I_D$| - $V_G$ transfer curves at $V_D$ = 1 V for the SBTFTs having a barrier inhomogeneity 1 $\mu$m from a drain contact end of the respective Schottky source contacts 150 for oxide semiconductor channel thicknesses $H$ of 10 nm, 20 nm, 30 nm, 50 nm and 100 nm. The barrier inhomogeneity has a width $L_0$ of 10 nm and a magnitude $\Delta$ = 0.3 eV. A mean barrier height $\Phi_B^0$ is 0.5 eV. A lower barrier region (LBR) is at a distance $P$ of 100 nm from a drain contact end of the Schottky source contact 150. The results of these simulations are comparable with the experimental results as shown in Figure 2I. Similar results may also be shown for different values of $\Delta$ and the mean barrier height $\Phi_B^0$.

Figure 3K shows simulated |$I_D$| - $V_G$ transfer curves at $V_D$ = 10 V for the SBTFTs having a barrier inhomogeneity 1 $\mu$m from a drain contact end of the respective Schottky source contacts 150 for oxide semiconductor channel thicknesses *H* of 10 nm, 20 nm, 30 nm, 50 nm and 100 nm. The barrier inhomogeneity has a width $L_0$ of 10 nm and a magnitude $\Delta$ = 0.3 eV. A mean barrier height $\Phi_B^0$ is 0.5 eV. A lower barrier region (LBR) is at a distance *P* of 100 nm from a drain contact end of the Schottky source contact 150. The results of these simulations are comparable with the experimental results as shown in Figure 2J. Similar results may also be shown for different values of $\Delta$ and the mean barrier height $\Phi_B^0$.

Figure 3L compares the profiles of the conduction band minimum along the vertical dashed line in Figure 3E from the centre of the inhomogeneity at zero bias for different semiconductor thicknesses.

For thicker semiconductor layers, a saddle point is established beneath the inhomogeneity due to depletion by the surrounding higher barrier regions. As the IGZO is made thinner, the electric field increases and reduces the saddle point height until at a certain thickness it is removed entirely.

Figure 3L schematically depicts $E_C$ - *z* depth profiles of conduction band minima for Schottky barrier thin-film transistors according to exemplary embodiments. Particularly, Figure 3L shows $E_C$ - *z* depth profiles of the conduction band minima beneath a centre of inhomogeneity at zero bias (i.e. *V* = 0 V) as a function of oxide semiconductor channel thickness *H* for oxide semiconductor channel thicknesses *H* of 10 nm, 20 nm, 30 nm, 50 nm and 100 nm. The oxide semiconductor is IGZO. The barrier inhomogeneity has a width $L_0$ of 10 nm and a magnitude $\Delta$ = 0.3 eV. A lower barrier region (LBR) is at a distance *P* of 100 nm from a drain contact end of the Schottky source contact 150. A mean barrier height $\Phi_B^0$ is 0.5 eV. A dependence of the effective barrier height on the oxide semiconductor channel thickness H is shown.

The conduction band $E_C$ minima at the interface of the Schottky source contact 150 - oxide semiconductor 140 is the same for all oxide semiconductor channel thicknesses *H* of 10 nm, 20 nm, 30 nm, 50 nm and 100 nm.

The $E_C$ - *z* depth profiles for oxide semiconductor channel thicknesses *H* of 20 nm, 30 nm, 50 nm and 100 nm have respective saddle points SP ($SP_{20\,nm}$, $SP_{30\,nm}$, $SP_{50\,nm}$, $SP_{100\,nm}$) (i.e. maxima). For these $E_C$ - *z* depth profiles for oxide semiconductor channel thicknesses *H* of 20 nm, 30 nm, 50 nm and 100 nm, the conduction band minima $E_C$ increase away from the interface of the Schottky source contact 150 - oxide semiconductor 140 through the oxide semiconductor 140, having respective maxima at the respective saddle points $SP$ ($SP_{20\,nm}$, $SP_{30\,nm}$, $SP_{50\,nm}$, $SP_{100\,nm}$) before decreasing monotonically away from the interface through the oxide semiconductor 140. The respective saddle points $SP_{20\,nm}$, $SP_{30\,nm}$, $SP_{50\,nm}$, $SP_{100\,nm}$ are at respective depths of approximately 4 nm, 6 nm, 9 nm and 14 nm.

The $E_C$ - z depth profile for the oxide semiconductor channel thicknesses *H* of 10 nm does not have a saddle point. Rather, the maximum of the conduction band minimum $E_C$ for the oxide semiconductor channel thickness *H* of 10 nm is at the interface of the Schottky source contant 150 - oxide semiconductor 140 and the conduction band minimum $E_C$ decreases monotonically away from the interface through the oxide semiconductor 140.

From the experimental results, as described above with respect to Figures 3H and 3I, the exponential dependence of the current prior to saturation disappears as the oxide semiconductor channel thicknesses *H* is reduced. Figure 3L compares the profiles of the conduction band minimum $E_C$ for different oxide semiconductor channel thicknesses *H* at zero bias. An oxide semiconductor channel thickness *H* dependence of the saddle point *SP,* similar to that observed in Schottky diodes, is present. As the oxide semiconductor channel thickness *H* is reduced, the electric field increases and reduces a height of the saddle point *SP.* When the oxide semiconductor channel thickness *H* is sufficiently small, the saddle point *SP* is eventually removed entirely, such as when the oxide semiconductor channel thicknesses *H* of 10 nm, for this example. In the absence of a saddle point *SP*, the effective barrier height of the inhomogeneity 180 loses its voltage dependence and the drain current $I_D$ will no longer increase exponentially with drain voltage $V_D$. Thus, the experimental trend is reproduced. This effect occurs for all inhomogeneities except those at the edge of the Schottky source contact 150, which cannot be pinched-off and so do not have a saddle point. If the Schottky source contact 150 is sufficiently long, injection from the edge of the Schottky source contact 150 can be discounted as other contributions dominate. Once the saddle point *SP* is lowered, the current dependence on voltage prior to saturation becomes linear as the diffusion current is only dependent on the increase in electric field, which should occur linearly with drain voltage $V_D$.

Once drain voltage $V_D$ is large enough to deplete the oxide semiconductor 140 under the edge of the Schottky source contact 150, the SBTFT 100 saturates regardless of whether output was linear or exponential. However, just as in the experiments described above, there remains a dependence of the oxide semiconductor channel thicknesses *H* on the output impedance. Unlike the case prior to source saturation, the output impedance cannot be significantly affected by inhomogeneities everywhere in the Schottky source contact 150. This is because the potential from the drain contact 160 cannot penetrate to the source after saturation. The potential can penetrate the region at the front end of the Schottky source contact 150 and it is here that the small variations in barrier height can produce the changes in current that limit output impedance. Even the small changes in potential that get through are amplified by an exponential dependence of the current at the saddle point *SP.* Again, by reducing the oxide semiconductor channel thickness *H,* these saddle points *SP* are removed, leading to a voltage independent barrier height (ignoring image force lowering and tunnelling effects) and a higher output impedance, as shown in Figures 3H and 3I. That barrier inhomogeneities 180 are the cause of this behaviour is further supported by simulated transfer curves, described with respect to Figures 3I and 3J.

*Intrinsic gain*

As revealed in device simulations, the intrinsic gain in our Schottky barrier thin-film transistors is extremely high due to the removal or near removal of saddle points in the conduction band minimum. The intrinsic gain $A_V$ is the maximum voltage gain of a TFT and is thus an important measure of the TFT's ability to amplify a signal. Particularly, the intrinsic gain $A_V$ of a TFT may be considered to be a figure of merit thereof. In display applications, TFTs having high intrinsic gains $A_V$ may behave as excellent constant current sources. Furthermore, higher intrinsic gains $A_V$ may also give greater noise margins in logic circuits, leading to greater immunity to noise. The intrinsic gain $A_V$ may be calculated as the ratio of transconductance $g_m$ to output conductance $g_d$ or a product of the transconductance $g_m$ and an output resistance $r_0$:

$$A_V = \frac{g_m}{g_d}$$

or

$$A_V = g_m r_o$$

where

$$g_m = \frac{\mathrm{d}I_D}{\mathrm{d}V_G}$$

and

$$g_d = \frac{1}{r_o} = \frac{\mathrm{d}I_D}{\mathrm{d}V_D}$$

Currently, the intrinsic gain in an Si MOSFET is limited to 20 to 40, while for poly-Si TFTs having long channels, the intrinsic gain has been shown to be more than 100. Given the behaviour of the saddle point, it is possible to try to maximise intrinsic gain by reducing the thickness of the IGZO in our devices.

However, extracting the intrinsic gain directly from the $I$-$V$ characteristics of our SBTFTs is extremely challenging due to the unprecedented flatness of the output curves. Such flatness requires highly precise measurement of minute changes in $I_D$ down to the very limit of our measurement set-up resolution.

The output curves (for the SBTFT with 20 nm thick IGZO) in Figure 5A demonstrate changes in current as low as a few pA over a wide range of $V_D$ from 15 to 60 V. The solid red line is a linear fitting of the results between 15 and 60 V and the dashed lines are a guide to the extent of the fluctuation.

Intrinsic gains of 19,000, 29,000 and 11,000 were obtained for VG = 10, 20 and 30 V, respectively, using the linear fittings in Figure 5A. Using 15 point smoothing (Savitzky-Golay) of the output curves, the obtained gain values have good agreement with the linear fitting results, with some of the gain values even higher than 100,000 at certain biases (Figure 5B). To further confirm the extremely high gain, the Schottky barrier thin-film transistor was connected in an inverter set-up, using a current source as a load (Figure 5C, inset). The abrupt inversion gives a gain of 6,200, only limited by a drain compliance of 60 V.

Figure 5D schematically depicts intrinsic gains $A_V$ as functions of drain voltage $V_D$ for a Schottky barrier thin-film transistor 100 according to exemplary embodiments. Particularly, Figure 5D shows intrinsic gains $A_V$ plotted against drain voltage $V_D$ for a gate contact voltage $V_G$ of 40 V for the SBTFTs 100 having oxide semiconductor channel thicknesses $H$ of 10 nm, 20 nm, 30 nm and 50 nm and wherein the oxide semiconductor is IGZO.

As shown in Figure 5D, the SBTFT 100 having an oxide semiconductor channel thicknesses $H$ of 20 nm, wherein the oxide semiconductor is IGZO, achieves the highest intrinsic gain $A_V$ of approximately 3,000 over a large range of drain voltages $V_D$, compared with other oxide semiconductor channel thicknesses $H$ of 10 nm, 20 nm, 30 nm and 50 nm. The SBTFT 100 having an oxide semiconductor channel thicknesses $H$ of 50 nm has an intrinsic gain $A_V$ of up to about 20 at a drain voltage $V_D$ of 15 V. The SBTFTs 100 having oxide semiconductor channel thicknesses $H$

of 20 nm and 30 nm respectively have similar intrinsic gains $A_V$ of up to about 100 at a drain voltage $V_D$ of 15 V. Particularly, the intrinsic gain $A_V$ of approximately 3,000, for the SBTFT 100 having the oxide semiconductor channel thicknesses $H$ of 20 nm, represents a huge improvement compared with a standard TFT. Compared to SBTFTs in other materials, the SBTFT 100 maintains an intrinsic gain $A_V$ of over 1,000 over a far larger range of voltages. While some polysilicon SBTFTs have intrinsic gains $A_V$ of up to 10,000 for very narrow ranges of drain voltage, $V_D$, oxide semiconductor SBTFTs have thus far been limited to intrinsic gains $A_V$ of only about 400. This huge improvement in intrinsic gain $A_V$ of the SBTFTs 100 would not be possible through understanding the conventional operating mechanism of the SBTFT alone. Rather, detailed knowledge of barrier inhomogeneities, which are especially prevalent in oxide semiconductor Schottky junctions, is equally important. As a first effect, the source saturation shields the source region from large variations in potential. As a second effect, by reducing the oxide semiconductor channel thicknesses $H$, saddle points $SP$ in the conduction band minima $E_C$, beneath the lower barrier regions provided at least in part by the barrier inhomogeneities, are reduced or removed. Combined, these two effects serve to prevent small variations in the drain voltage $V_D$ causing otherwise large changes in the drain current $I_D$, thus maintaining a near constant current $I_D$.

Reducing the oxide semiconductor channel thicknesses $H$ down to 10 nm, in this example, did not improve the intrinsic gain $A_V$ further, as shown in Figure 5D. Rather, in SBTFTs 100 having such small oxide semiconductor channel thicknesses $H$, the electric field becomes so large that tunnelling and other barrier lowering mechanisms additionally affect the saturation current of the output curve. The maximum intrinsic gain $A_V$ achieved in these examples may be dependent upon limiting gate contact leakage and/or traps that lead to hysteresis. These factors can make the gain measurements noisy, especially in such high gain SBTFTs 100.

*Short channel effect*

To achieve high integration densities transistor dimensions must be scaled down, but the short-channel effect has been the main obstacle to such scaling. In the case of IGZO TFTs, reducing the channel length below 5 $\mu$m produces a high enough electric field to make the saturation current strongly dependent upon $V_D$. In comparison, SBTFTs are more resilient to the short-channel effect because the source region determines the current rather than the channel and its dimensions.

Using electron-beam lithography, the inventors fabricated IGZO SBTFTs with channel lengths of 360, 602 and 1640 nm. Scanning electron microscope (SEM) images of the three channels are shown in Figure 6A. Figures 6B, 6C and 6D show that flat saturation up to $V_D$ = 20 V is maintained down to channel lengths of 360 nm. To the best of our knowledge such an immunity to the short channel effect has never been demonstrated with oxide semiconductors. Moreover, the current is highly consistent regardless of channel length, meaning that the SBTFTs are tolerant to alignment variations, which is of great importance to large-area electronics.

*Negative bias illumination temperature stress*

In conventional TFTs, the oxide semiconductor, for example IGZO, channel is very sensitive to the combination of light and negative gate bias stress, known as Negative Bias Illumination Temperature Stress (NBITS). This causes the threshold voltage of the conventional TFTs to shift negatively during use and is a big problem for display applications which have back lights. The SBTFT 100 removes this problem almost entirely, by making the behaviour dependent on the source region only, thus removing the need for an extra shielding layer, as described below in more detail.

When conventional IGZO TFTs are held at negative bias under illumination of near band gap energy photons, there is a large negative shift in the threshold voltage $V_T$ of the oxide semiconductor channel. This instability has been attributed to the presence of deep traps formed by oxygen vacancies, although the mechanism for this is still not fully understood. The near-bandgap light will excite electrons (holes) into the conduction (valance) band. The holes will be drawn towards the gate contact by the electric field and can become trapped either at the interface or in the gate dielectric. Once the bias is removed, these holes can remain trapped, leading to electron accumulation on the IGZO-side of the interface. While the threshold voltage $V_T$ shift can be reduced by various measures including high pressure annealing and asymmetric source-drain contacts, until now it remains impractical to incorporate IGZO SBTFTs into displays without implementing light shielding measures. Such light shielding measures negate any advantages of transparency that may be offered by IGZO SBTFTs as well as introducing an additional fabrication step.

In contrast, the SBTFTs 100 do not exhibit the negative shift in the threshold voltage $V_T$ exhibited by conventional IGZO TFTs. Negative bias illumination stress tests were carried out on our 20 nm thick IGZO SBTFTs 100. The devices were held at $V_G$ = -20 V and 60 °C under illumination from a 2,000 lx white LED. Despite twenty hours of stress, the device exhibited no discernible shift in $V_{ON}$, as shown in Figure 7. This high stability can be attributed to independence of the current from the channel conductivity. The high resistance of the source region will mask any channel instability. The immunity to NBITS removes a lasting obstruction to wide deployment of oxide semiconductors in the display industry.

*Application to other oxide materials*

The understanding of the working principle and design methodology in this work even removes the usual restriction that the channel layer can only be a semiconductor. Here a semi-metal-like oxide ITO is tested. The use of such a material is difficult in ordinary TFTs, as shown by the lack of gate modulation in the ITO TFT (Figure 8A). However, the output characteristics of an ITO SBTFT, as shown in Figure 8B, are comparable with the IGZO SBTFT in Fig. 2M. The ITO SBTFT demonstrates that our Schottky source contact design can broaden the range of materials used for channel layers.

*Simulations*

Device simulations were carried out using Silvaco Atlas. Atlas solves Poisson's equation, the charge carrier continuity equations and the charge transport equations. SBTFT structures were simulated with a barrier inhomogeneity 180 inserted into the Schottky source contact 150. The barrier height $\Phi_B^0$ of the Schottky contact source 150 was fixed at 0.5 eV except at the inhomogeneity 180 where the barrier height was $\Phi_B^0 - \Delta$. Only inhomogeneities with a barrier height lower than $\Phi_B^0$ were considered, as higher barriers would not contribute significantly to the current. Hence, the value of $\Delta$ was varied from 0, simulating a homogeneous source, to 0.3 eV. Inhomogeneity distance $P$ with respect to the drain contact 160 end of the Schottky contact source 150 edge was varied, with $P$ being 0, 10, 100, 1000 and 4000 nm. The inhomogeneity width $L_0$ was also varied, with $L_0$ being 3, 10 and 30 nm. Unless specified, the source length $S$ and channel length $L_{CH}$ were fixed at 5 μm and 2 μm, respectively. Oxide semiconductor channel thicknesses $H$ were of 10 nm, 20 nm, 30 nm, 50 nm and 100 nm. The oxide semiconductor was IGZO and the default Atlas model for IGZO was used. The dielectric was SiO$_2$ and the dielectric thickness was fixed at 100 nm. The length of the drain contact 160 was fixed at 1 μm and the gate contact overlapped the entirety of the device. The channel width $L_{CH}$ was fixed at 1 μm.

*Fabrication of Schottky diodes*

IGZO-Pt Schottky diodes 10 were fabricated using Ti as an Ohmic contact. SiO$_2$-Si wafers, providing the substrate 11, 12, were cleaned by sonic agitation in an ultrasonic bath using DECON 90, de-ionized water, acetone and isopropyl alcohol, respectively. Using radio-frequency (RF) sputtering of a Ti target, a 70 nm thick Ti layer was deposited on the wafers, to provide the Ohmic contact layer 13. For Ti sputtering, the working gas was Ar, the pressure was 5 × 10$^{-3}$ mbar and the sputtering power was 150 W. A 150 nm thick IGZO layer was deposited via RF sputtering using an IGZO target with a molar ratio of 1:1:2 (In$_2$O$_3$:Ga$_2$O$_3$:ZnO), available from the Kurt J Lesker Company Ltd (UK). For IGZO sputtering, the working gas was Ar, the pressure was 5×10$^{-3}$ mbar and the sputtering power was 100 W. Prior to Pt deposition, the structure was annealed at 300 °C in an N$_2$ atmosphere for 1 hour. A 70 nm Pt layer, to form the Schottky source contact 15, was also deposited by RF sputtering a Pt target, available from Leybold Materials GmbH (Germany) in either pure Ar or 3% O$_2$/Ar mix at a pressure of 5 × 10$^{-3}$ mbar at a sputtering power of 60 W and for a 3 inch diameter target (i.e. a sputtering power of 60 W corresponds to 1.32 W/cm$^2$), unless otherwise stated. The Schottky diodes were patterned using shadow masks.

*Fabrication of Schottky barrier thin-film transistors*

SBTFTs 100 and TFTs were fabricated using SiO$_2$-Si wafers with 100 nm thick SiO2. The wafers were cleaned by sonic agitation in an ultrasonic bath using DECON 90, de-ionized water, acetone and isopropyl alcohol, respectively. The oxide semiconductor channel 140 was IGZO, deposited via RF sputtering using an IGZO target with a molar ratio of 1:1:2 (In$_2$O$_3$:Ga$_2$O$_3$:ZnO) available from the Kurt J Lesker Company Ltd (UK). The working gas was Ar, the pressure was 5×10$^{-3}$ mbar and the sputtering power was 100 W. Prior to Pt deposition, the structure was annealed at 300 °C in an N$_2$ atmosphere for 1 hour. A 70 nm Pt layer, to form the Schottky source contact 150 and the drain contact 160, was also deposited by RF sputtering a Pt target available from Leybold Materials GmbH (Germany) in either pure Ar or 3% O$_2$/Ar mix at a pressure of 5 × 10$^{-3}$ mbar and at a sputtering power of 60 W, unless otherwise stated. The IGZO TFTs were fabricated in a similar manner to the SBTFTs, but Ti source and drain contacts were used instead of Pt and were sputtered in the same way as for the Schottky diodes. Except for the channel layer, ITO SBTFTs were fabricated in a similar manner to the IGZO SBTFTs; the ITO target was sputtered in Ar, at a pressure of 5×10$^{-3}$ mbar and a sputtering power of 100 W. The SBTFTs 100 and TFTs were patterned using shadow masks and photolithography, except for the short-channel SBTFTs 100 which were patterned using standard electron beam lithography.

*Measurement of device characteristics*

The standard *I - V* characteristics of all devices were measured using a Keysight E5270B semiconductor analyser at room temperature. For the calculation of intrinsic gain, the output curves of IGZO SBTFT were measured using a Keysight E5270B in pulsed mode with a period of 600 ms and averaged for 30 times. The low temperature measurements of IGZO Schottky diodes were carried out using a Lakeshore cryogenic CRX-4K probe station. The SEM images were taken using a Zeiss Sigma field emission scanning electron microscope. The bias stress measurement was carried out on the Advanced Research Systems DE-204 temperature controlled stage.

*Method*

Figure 12 schematically depicts a method of forming a Schottky source contact on an oxide-semiconductor channel according to an exemplary embodiment.
At S801, the source contact is deposited on the oxide semiconductor channel in an atmosphere comprising oxygen.
The method may include any of the steps described herein.
Figure 13 schematically depicts a method of forming a Schottky source contact on an oxide-semiconductor channel according to an exemplary embodiment.
The oxide semiconductor channel is amorphous $a(In_2O_3).b(Ga_2O_3).c(ZnO)$, wherein a = 1, b = 1 and c = 2, and wherein a thickness H of the oxide semiconductor channel is in a range from 5 nm to 50 nm, preferably in a range from 10 nm to 40 nm, more preferably in a range from 15 nm to 30 nm, for example 20 nm or 25 nm.
The source contact is platinum, for example.
At S901, the oxide semiconductor is annealed prior to depositing the source contact thereon. The annealing is in an inert atmosphere, preferably nitrogen, at a temperature in a range from 200 °C to 400 °C, preferably in a range from 250 °C to 350 °C, for example 300 °C for at least 30 minutes, preferably about 60 minutes.
At S902, the source contact is deposited on the oxide semiconductor channel in an atmosphere comprising oxygen. The atmosphere comprising the oxygen may be an inert gas, preferably argon, comprising the oxygen in a range from 0.1 % to 10 %, preferably in a range from 1 % to 5 %, for example 3% by partial pressure. The pressure of the atmosphere may be in a range from $1 \times 10^{-5}$ mbar to $1 \times 10^{-1}$ mbar, preferably in a range from $1 \times 10^{-4}$ mbar to $1 \times 10^{-2}$ mbar, for example $5 \times 10^{-3}$ mbar. Depositing the source contact on the oxide semiconductor channel may comprise sputtering the source contact on the oxide semiconductor channel at a sputtering power in a range from 0.4 $W/cm^2$ to 3 $W/cm^2$, preferably in a range from 0.6 $W/cm^2$ to 1.7 $W/cm^2$, for example 0.88 $W/cm^2$ or 1.32 $W/cm^2$. These sputtering powers correspond with a sputtering power in a range from 20 W to 150 W, preferably in a range from 30 W to 80 W, for example 40 W or 60W, respectively, for a 3 inch diameter sputtering target, as used herein.
The method may include any of the steps described herein.

*Measurement*

Room temperature measurements were carried out on a probe station and the diodes 10 and SBTFTs 100 were contacted with probes tips controlled using micromanipulators. For negative bias illumination temperature stress measurements, the SBTFTs were glued to a chip carrier and bonded with gold wire, prior to being connected to a temperature controlled stage inside a Advanced Research Systems, Inc. 4K cryostat. The source of illumination was a white LED (around 2000~lx) at a distance of 3-cm away from the SBTFTs. An Agilent E5260B semiconductor analyzer, contolled by an in-house Labview program, was used for all electrical measurements.

*XPS measurement*

XPS measurements were carried out using an Axis Ultra Hybrid (Kratos, Manchester UK), run at 10 mA emission with 15 kV bias. A charge neutraliser was used to remove any differential charging effects. The base pressure of the instrument was $10^{-8}$ mbar. The survey scan and the high resolution scans were run at 80 eV and 20 eV pass energies, respectively. High resolution scans were carried out on two ranges of interest, around the O 1s and Pt $4p_{3/2}$ peaks and the Pt $4f_{5/2}$ and $4f_{7/2}$ peaks, as well as the C 1s peak. The analysis was carried out with CasaXPS software. The binding energies were calibrated against the adventitious carbon peak at 284.8 eV. After calibration, the spectra were corrected by background subtraction. The spectra were fitted with a Gaussian-Lorentzian product formula, with the exception of Pt $4f_{5/2}$ and $4f_{7/2}$ peaks, which were fitted with an asymmetric LA function.
*XPS*
When Pt is deposited in Ar there is no metal oxide component to the O 1s peak. Sputtering the Pt in 3% $O_2$/Ar leads to the formation of a metal oxide peak around 530 eV. At 60 W, the ratio of the O 1s to the Pt $4p_{3/2}$ peak areas was about 1:4. At 40 W, the ratio increased to around 4:5, indicating increased oxidation. The Pt $4f_{5/2}$ and $4f_{7/2}$ peaks shift to the left, when oxygen is included in the sputtering gas and again when the power is lowered from 60 to 40 W. The left shift indicates increasing oxidation, with peaks attributed to PtO, PtOz and high oxygen content Pt making increasingly large contributions as the sputtering power is lowered. The increased oxidation at lower sputtering power can be attributed to the longer deposition time allowing for the inclusion of more oxygen in the film.

*Inhomogeneity Position*

The contribution of a lower barrier region to the current is strongly dependent on its distance from the edge of the source nearest the drain, *P.* As shown in the output curves in Figures 11A, 11B and 11C, the nearer the inhomogeneity is to the drain end of the source, the greater is $I_D$. In Figure 11C, the current grows exponentially prior to saturation in all cases except when the inhomogeneity is at the edge of the source, i.e. $P = 0$ nm. At the edge, the inhomogeneity cannot be pinched off and no saddle point can form in the conduction band. Under these circumstances there is no voltage dependence of the effective barrier height and no exponential growth of current. The reason that the current is so strongly dependent on the position is because of the lateral resistance beneath the source. The further from the source edge the lower the potential at the interface. Thus, regions further from the source edge are less reverse-biased and so give a smaller current. As the inhomogeneity dominates the current, the further from the source edge it is, the lower the total current from the source.

For similar reasons, the output impedance is also strongly dependent upon the position of inhomogeneity. When the device saturates at the source the potential at the semiconductor dielectric interface beneath the source is fixed and independent of $V_D$, except in the front 200 nm or so of the source (Figure 11D). Hence, inhomogeneities within 200 nm of the source edge are only the ones that are affected by $V_D$ in saturation, making them limiting factor for the output impedance, and therefore the intrinsic gain.

*SBTFT theory*

Besides simulations, an analytical theory can be derived to allow for further understanding of device behaviour. In high gain devices the saddle points no longer have a significant effect and the effective barrier height $\Phi_{B,eff}$ at the source is given, as detailed below, by Equation 1:

$$\Phi_{B,eff} = \Phi_B^0 - \Phi_{IFL} - \alpha q \varepsilon_M$$

where $\Phi_{IFL}$ and $\alpha q \varepsilon_M$ are barrier lowering terms due to the image force effect and the electric field, respectively. In a SBTFT, most of the current passes through the front end of the source, and our detailed analysis shows that the current $I_{lin}$ in the linear regime is given, as detailed below, by Equation 2:

$$I_{lin} = W \sqrt{\frac{q N_C C_G (V_G - V_T) \exp\left(-\frac{\Phi_{B,eff}}{kT}\right)}{H}} \times \mu_n (\phi_B^0 + V_D) \left[1 - \exp\left(-\frac{q V_D}{kT}\right)\right]$$

Similarly, in the saturation regime the current $I_{sat}$ is given by Equation 3:

$$I_{sat} = W \sqrt{\frac{q N_C C_G (V_G - V_T) \exp\left(-\frac{\Phi_{B,eff}}{kT}\right)}{H}} \times \mu_n \left[\frac{C_G}{C_S + C_G}(V_G - V_T) + \frac{\phi_B^0}{q}\right]$$

where $W$ is the source contact width, $q$ is the fundamental charge, $\mu_n$ is the electron mobility in the semiconductor, $N_C$ is the effective density of states in the conduction band, $V_T$ is the threshold voltage of the SBTFT, $k$ is the Boltzmann constant, $T$ is the temperature and $C_S$ and $C_G$ are the capacitance per unit area of the semiconductor and the gate insulator, respectively. In the present experiment, $\mu_n = 10.6$ cm$^2$/Vs (obtained from an IGZO TFT), $W = 2$ mm and the relative permittivity is 3.9 for SiOz and 10 for IGZO. The experimental transfer curve (circles) in Figure 4C shows a very good agreement with the values obtained from Equation 3 (solid). The fitting also yields $\alpha = 0.73$ nm, $V_T = 11.7$ V and

$\phi_B^0 = 0.74$ eV , which agrees almost perfectly with the results for barrier height in Figure 9C. Using these same parameters, the output curves also agreed very well with the theory (Figure 4C). The above results indicate that our analytical formulae offer an accurate description of the *I* - *V* characteristics of an SBTFT.

In more detail, this theory applies for the high-gain condition only, i.e. the effects of the saddle points can be considered negligible, due to the semiconductor being made sufficiently thin or otherwise. In reverse bias, the current from the source is diffusion limited and given by Equation 4:

$$J_V(x) \approx q\mu_n N_C \varepsilon_M(x) \exp\left(-\frac{\Phi_B}{kT}\right)\left[1 - \exp\left(-\frac{qV_{int}(x)}{kT}\right)\right]$$

where $J_V(x)$ is the vertical current density from the source at position $x$, $q$ is the fundamental charge, $\mu_n$ is the electron mobility in the semiconductor, $N_C$ is the effective density of states in the conduction band, $\varepsilon_M(x)$ is the electric field at the Schottky interface, $\Phi_B$ is the barrier height, $V_{int}(x)$ is the potential at the semiconductor-dielectric interface at position $x$, $k$ is the Boltzmann constant and $T$ is the temperature. The band diagram is described in Figure 4A. At position x:

$$\varepsilon_M(x) \approx \frac{\phi_B^0 + V_{int}(x)}{H}$$

where $\phi_B^0$ is the mean barrier height potential ( $\phi_B^0 = \Phi_B^0/q$ ) and $H$ is the thickness of the semiconductor. Thus, the vertical current density from the source at position $x$ is given by Equation 5:

$$J_V(x) \approx q\mu_n N_C \frac{\phi_B^0 + V_{int}(x)}{H} \exp\left(-\frac{\Phi_B}{kT}\right)$$

When $V_D \gg \phi_B^0$ , we assume that the majority of current injection occurs where $V_{int} \gg \phi_B^0$ . Hence, the resisitivity $\rho_V$ at position $x$ can be given by Equation 6:

$$\rho_V \approx \frac{V_{int}}{J_V} \approx \frac{H}{q\mu_n N_C \exp\left(-\frac{\Phi_B}{kT}\right)}$$

If we assume that $V_D \ll (V_G - V_T)$, where $V_G$ is the gate voltage and $V_T$ is the threshold voltage of the SBTFT, then beneath the source the resistance $R_L$ along the semiconductor-insulator interface is given by Equation 7:

$$R_L \approx \frac{1}{\sigma_{ch}} = \frac{1}{q\mu_n N_{ch}} \approx \frac{1}{\mu_n C_G (V_G - V_T)}$$

where $\sigma_{ch}$ is the conductivity of the channel, $N_{ch}$ is the electron density on the channel, $C_G$ is the capacitance per unit area of the gate dielectric and $V_T$ is the threshold voltage of the SBTFT.

Therefore, the effective source length is given by Equation 8:

$$L_{eff} = \sqrt{\frac{\rho_V}{R_L}} = \sqrt{\frac{HC_G(V_G - V_T)}{qN_C \exp\left(-\frac{\Phi_B}{kT}\right)}}$$

To calculate the threshold voltage of the SBTFT, consider that the mean barrier height potential $\phi_B^0$ is given by Equation 9:

$$\phi_B^0 = \frac{C_G}{C_S + C_G}(V_T - V_{T-TFT})$$

where $C_S$ is the capacitance per unit area of the semiconductor and $V_{T-TFT}$ is the threshold voltage of the semiconductor channel. Thus, the threshold voltage $V_T$ of the SBTFT is given by Equation 10:

$$V_T = V_{T-TFT} + \frac{C_S + C_G}{C_G}\phi_B^0$$

Prior to saturation, where $V_D$ does not cause full depletion of the semiconductor beneath the edge of the source (Fig. 4B), the current can be estimated in two different circumstances. If the source length $S \gg L_{eff}$, then the linear current $I_{lin}$ is given by Equation 11 (same as Equation 2):

$$I_{lin} = WL_{eff}J_V = W\sqrt{\frac{qN_C C_G(V_G - V_T)\exp\left(-\frac{\Phi_B}{kT}\right)}{H}} \times \mu_n(\phi_B^0 + V_D)\left[1 - \exp\left(-\frac{qV_D}{kT}\right)\right]$$

When $L_{eff} \gg S$, then the linear current $I_{lin}$ is given by Equation 12:

$$I_{lin} = WSJ_V = WSq\mu_n N_C \frac{\phi_B^0 + V_D}{H}\exp\left(-\frac{\Phi_B}{kT}\right)\left[1 - \exp\left(-\frac{qV_D}{kT}\right)\right]$$

Similarly, in the saturation regime, based on the series capacitance model, the saturation drain voltage $V_{Dsat}$ is given by Equation 13:

$$V_{Dsat} \approx \frac{C_G}{C_S + C_G}(V_G - V_T)$$

If the source length $S \gg L_{eff}$, then the saturation current $I_{sat}$ is given by Equation 14:

$$I_{sat} = WL_{eff}J_V = W\sqrt{\frac{qN_C C_G(V_G - V_T)\exp\left(-\frac{\Phi_B}{kT}\right)}{H}} \times \mu_n\left[\frac{C_G}{C_S + C_G}(V_G - V_T) + \phi_B^0\right]$$

If the source length $S \ll L_{eff}$, then the saturation current $I_{sat}$ is given by Equation 15:

$$I_{sat} = WSJ_V = WSq\mu_n N_C \frac{\frac{C_G}{C_S + C_G}(V_G - V_T) + \phi_B^0}{H}\exp\left(-\frac{\Phi_B}{kT}\right)$$

If considering image force lowering, then the barrier height is given by Equation 16:

$$\Phi_{IFL} = q\sqrt{\frac{q\varepsilon_M}{4\pi\epsilon_0\epsilon_s}} = q\sqrt{\frac{q\left[\frac{C_G}{C_S + C_G}(V_G - V_T) + \phi_B^0\right]}{4\pi\epsilon_0\epsilon_s H}}$$

Based on recent research, the Pt-IGZO interface is not abrupt. There is a transition region where Pt clusters are encapsulated by In, which may lead to interfacial states. Such interfacial states are can lead to a barrier lowering effect with a magnitude of $\alpha q\varepsilon_M$. Similar trends can also be attributed to tunnelling or the electric field penetrating the metal. Combining these effects, the effective barrier at the source is given by Equation 17 (same as Equation 1):

$$\Phi_{B,eff} = \Phi_B^0 - \Phi_{IFL} - \alpha q \varepsilon_M$$

By substituting $\Phi_{B,eff}$ for $\Phi_B$ in the equations for $I_{lin}$ and $I_{sat}$ we arrive at the formulae for fitting the I-V characteristics as shown in Figures 4C and 4D.

*Modifications*

Although a preferred embodiment has been shown and described, it will be appreciated by those skilled in the art that various changes and modifications might be made without departing from the scope of the invention, as defined in the appended claims and as described above.

*Summary*

In summary, the invention provides a method of forming a Schottky source contact upon an oxide semiconductor channel that improves an intrinsic gain, a resistance to short channel effect and/or a resistance to negative bias illumination temperature stress.

Despite being invented over 70 years ago, it is still possible to develop new transistor designs, including adding a Schottky-diode-like source electrode. By finding a way to control the shape and position of the diode barrier and derivation of analytical theory, an extremely high voltage-amplification gain up to 29,000 has been achieved, which is orders of magnitude higher than a conventional Si transistor. These same devices demonstrate almost total immunity to negative bias illumination temperature stress, the foremost bottleneck to using oxide semiconductors in major applications, such as display drivers. Furthermore, devices fabricated with channel lengths of 360 nm display no obvious short-channel effects, another critical factor for high-density integrated circuits and display applications.

By gaining a deeper understanding of the device physics of SBTFTs, particularly the control of the barrier, the inventors have, to the best of their knowledge, achieved an unprecedented gain in thin-film transistors. Furthermore, the same devices are rendered immune to two of the most critical issues facing oxide transistors in industry, NBITS and the short-channel effect. As such, these devices have a huge potential for applications in large-area displays, logic gates and analogue circuits.

**Claims**

1.  A method of forming a Schottky source contact on an oxide semiconductor channel for a Schottky barrier thin-film transistor, SBTFT, the method comprising:

    controlling a thickness $H$ of the oxide semiconductor channel in a range from 5 nm to 50 nm; and
    depositing the source contact on the oxide semiconductor channel in an atmosphere comprising oxygen; wherein depositing the source contact on the oxide semiconductor channel comprises sputtering the source contact on the oxide semiconductor channel at a sputtering power in a range from 0.4 W/cm$^2$ to 3 W/cm$^2$.

2.  The method according to claim 1, wherein depositing the source contact on the oxide semiconductor channel comprises sputtering the source contact on the oxide semiconductor channel at a sputtering power in a range from 0.6 W/cm$^2$ to 1.7 W/cm$^2$.

3.  The method according to any previous claim, wherein the atmosphere comprising the oxygen is an inert gas comprising the oxygen in a range from 0.1 % to 10 % by partial pressure.

4.  The method according to any previous claim, wherein sputtering the source contact on the oxide semiconductor channel comprises sputtering the source contact on the oxide semiconductor channel to a thickness in a range from 10 nm to 250 nm.

5.  The method according to any of claims 3 to 4, wherein a pressure of the atmosphere is in a range from $1 \times 10^{-5}$ mbar to $1 \times 10^{-1}$ mbar.

6.  The method according to claim 5, wherein the pressure of the atmosphere is in a range from $1 \times 10^{-4}$ mbar to $1 \times$

$10^{-2}$ mbar.

7. The method according to any previous claim, wherein the oxide semiconductor comprises and/or is a ZnO-based oxide semiconductor.

8. The method according to claim 7, wherein the oxide semiconductor is amorphous $a(In_2O_3).b(Ga_2O_3).c(ZnO)$, wherein a, b, and c are real numbers where $a \geq 0$, $b \geq 0$, and/or $c > 0$.

9. The method according to claim 8, wherein $a \geq 1$, $b \geq 1$, and/or $0 < c \leq 1$.

10. The method according to any previous claim, comprising controlling the thickness H of the oxide semiconductor channel in a range from 10 nm to 40 nm.

11. The method according to any previous claim, wherein the source contact comprises and/or is formed of a material having a work function of at least 4.5 eV.

12. The method according to claim 10, wherein the source contact is Pt.

13. The method according to any previous claim, wherein the oxide semiconductor comprises an oxygen-depleted region within 5 nm of an interface between the oxide semiconductor channel and the source contact.

14. The method according to any previous claim, wherein the Schottky source contact comprises a multi-layer Schottky source contact and/or a Schottky source contact having a graded composition.

15. The method according to any previous claim, comprising arranging an interface layer between the source contact and the oxide semiconductor channel.

**Patentansprüche**

1. Verfahren zum Bilden eines Schottky-Source-Anschlusses an einem Oxid-Halbleiterkanal für einen Schottky-Barriere-Dünnschichttransistor, SBTFT, wobei das Verfahren umfasst:

Beeinflussen einer Dicke *H* des Oxid-Halbleiterkanals derart, dass sie in einem Bereich von 5 nm bis 50 nm liegt; und
Abscheiden des Source-Anschlusses auf dem Oxid-Halbleiterkanal in einer Atmosphäre, die Sauerstoff enthält; wobei das Abscheiden des Source-Anschlusses auf dem Oxid-Halbleiterkanal ein Sputtern des Source-Anschlusses auf den Oxid-Halbleiterkanal bei einer Sputterleistung in einem Bereich von 0,4 W/cm$^2$ bis 3 W/cm$^2$ umfasst.

2. Verfahren nach Anspruch 1, wobei das Abscheiden des Source-Anschlusses auf dem Oxid-Halbleiterkanal ein Sputtern des Source-Anschlusses auf den Oxid-Halbleiterkanal bei einer Sputterleistung in einem Bereich von 0,6 W/cm$^2$ bis 1,7 W/cm$^2$ umfasst.

3. Verfahren nach einem der vorhergehenden Ansprüche, wobei die Atmosphäre, die den Sauerstoff enthält, ein Inertgas ist, das den Sauerstoff in einem Bereich von 0,1 % bis 10 % Partialdruck enthält.

4. Verfahren nach einem der vorhergehenden Ansprüche, wobei das Sputtern des Source-Anschlusses auf den Oxid-Halbleiterkanal ein Sputtern des Source-Anschlusses auf den Oxid-Halbleiterkanal bis auf eine Dicke in einem Bereich von 10 nm bis 250 nm umfasst.

5. Verfahren nach einem der Ansprüche 3 bis 4, wobei ein Druck der Atmosphäre in einem Bereich von $1 \times 10^{-5}$ mbar bis $1 \times 10^{-1}$ mbar liegt.

6. Verfahren nach Anspruch 5, wobei der Druck der Atmosphäre in einem Bereich von $1 \times 10^{-4}$ mbar bis $1 \times 10^{-2}$ mbar liegt.

7. Verfahren nach einem der vorhergehenden Ansprüche, wobei der Oxid-Halbleiter einen Oxid-Halbleiter auf Basis von ZnO umfasst und/oder ein derartiger Oxid-Halbleiter ist.

8. Verfahren nach Anspruch 7, wobei der Oxid-Halbleiter amorphes $a(In_2O_3).b(Ga_2O_3).c(ZnO)$ ist, in dem a, b und c reelle Zahlen sind, bei denen $a \geq 0$, $b \geq 0$ und/oder $c > 0$.

9. Verfahren nach Anspruch 8, wobei $a \geq 1$, $b \geq 1$ und/oder $0 < c \leq 1$.

10. Verfahren nach einem der vorhergehenden Ansprüche, das ein Beeinflussen der Dicke $H$ des Oxid-Halbleiterkanals derart umfasst, dass sie in einem Bereich von 10 nm bis 40 nm liegt.

11. Verfahren nach einem der vorhergehenden Ansprüche, wobei der Source-Anschluss ein Material mit einer Arbeitsfunktion von mindestens 4,5 eV umfasst und/oder ein derartiges Material ist.

12. Verfahren nach Anspruch 10, wobei der Source-Anschluss Pt ist.

13. Verfahren nach einem der vorhergehenden Ansprüche, wobei der Oxid-Halbleiter einen sauerstoffverarmten Bereich innerhalb von 5 nm einer Grenzfläche zwischen dem Oxid-Halbleiterkanal und dem Source-Anschluss umfasst.

14. Verfahren nach einem der vorhergehenden Ansprüche, wobei der Schottky-Source-Anschluss einen mehrlagigen Schottky-Source-Anschluss und/oder einen Schottky-Source-Anschluss mit einer abgestuften Zusammensetzung umfasst.

15. Verfahren nach einem der vorhergehenden Ansprüche, umfassend ein Anordnen einer Grenzflächenschicht zwischen dem Source-Anschluss und dem Oxid-Halbleiterkanal.

**Revendications**

1. Procédé de formation d'un contact de source Schottky sur un canal semiconducteur d'oxyde pour un transistor en film mince à barrière de Schottky, SBTFT, le procédé comprenant :

   la régulation d'une épaisseur $H$ du canal semiconducteur d'oxyde dans une plage de 5 nm à 50 nm ; et
   le dépôt du contact de source sur le canal semiconducteur d'oxyde dans une atmosphère contenant de l'oxygène ;
   le dépôt du contact de source sur le canal semiconducteur d'oxyde comprenant une pulvérisation du contact de source sur le canal semiconducteur d'oxyde à une puissance de pulvérisation dans une plage de 0,4 $W/cm^2$ à 3 $W/cm^2$.

2. Procédé selon la revendication 1, le dépôt du contact de source sur le canal semiconducteur d'oxyde comprenant une pulvérisation du contact de source sur le canal semiconducteur d'oxyde à une puissance de pulvérisation dans une plage de 0,6 $W/cm^2$ à 1,7 $W/cm^2$.

3. Procédé selon une quelconque revendication précédente, l'atmosphère comprenant l'oxygène étant un gaz inerte comprenant l'oxygène en une plage de 0,1 à 10 % par pression partielle.

4. Procédé selon une quelconque revendication précédente, la pulvérisation du contact de source sur le canal semiconducteur d'oxyde comprenant une pulvérisation du contact de source sur le canal semiconducteur d'oxyde jusqu'à une épaisseur dans une plage de 10 nm à 250 nm.

5. Procédé selon l'une quelconque des revendications 3 à 4, une pression de l'atmosphère étant dans une plage de $1 \times 10^{-5}$ mbar à $1 \times 10^{-1}$ mbar.

6. Procédé selon la revendication 5, la pression de l'atmosphère étant dans une plage de $1 \times 10^{-4}$ mbar à $1 \times 10^{-2}$ mbar.

7. Procédé selon une quelconque revendication précédente, le semiconducteur d'oxyde comprenant et/ou étant un semiconducteur d'oxyde à base de ZnO.

8. Procédé selon la revendication 7, le semiconducteur d'oxyde étant $a(In_2O_3).b(Ga_2O_3).c(ZnO)$ amorphe, a, b et c étant des nombres réels où a $\geq$ 0, b $\geq$ 0, et/ou c > 0.

9. Procédé selon la revendication 8, a $\geq$ 1, b $\geq$ 1, et/ou 0 < c $\leq$ 1.

10. Procédé selon une quelconque revendication précédente, comprenant la régulation de l'épaisseur H du canal semiconducteur d'oxyde dans une plage de 10 nm à 40 nm.

11. Procédé selon une quelconque revendication précédente, le contact de source comprenant et/ou étant formé d'un matériau ayant un travail d'extraction d'au moins 4,5 eV.

12. Procédé selon la revendication 10, le contact de source étant Pt.

13. Procédé selon une quelconque revendication précédente, le semiconducteur d'oxyde comprenant une région appauvrie en oxygène dans les 5 nm d'une interface entre le canal semiconducteur d'oxyde et le contact de source.

14. Procédé selon une quelconque revendication précédente, le contact de source Schottky comprenant un contact de source Schottky multicouche et/ou un contact de source Schottky ayant une composition à gradient.

15. Procédé selon une quelconque revendication précédente, comprenant un agencement d'une couche d'interface entre le contact de source et le canal semiconducteur d'oxyde.

$h$

15

$H$

14

13

12

11

10

**Fig. 1A**

$S$

$h$

150

$L$

160

$H$

140

120

110

100

**Fig. 1B**

**Fig. 1C**

# Ohmic contacts

## Carrier accumulation

Source

Drain

IGZO

$I_D$

Gate Dielectric

Gate

## Fig. 2A

Schottky source

Carrier accumulation

Depletion envelope

Source

Drain

$I_D$

IGZO

Gate Dielectric

Gate

## Fig. 2B

**Fig. 2C**

**Fig. 2D**

Fig. 2E

Fig. 2F

Fig. 2G

Fig. 2H

**Fig. 2I**

**Fig. 2J**

Fig. 2K

Fig. 2L

**Fig. 2M**

**Fig. 3A**

**Fig. 3B**

**Fig. 3C**

**Fig. 3D**

**Fig. 3E**

**Fig. 3F**

**Fig. 3G**

**Fig. 3H**

**Fig. 3I**

**Fig. 3J**

**Fig. 3K**

**Fig. 3L**

Fig. 3M

$$qN_ce^{-\frac{q\Phi_B}{kT}} \longrightarrow$$

$\Phi_B$

$a$

$V_{int}$

Pt
Source

SiO₂

Gate

## Fig. 4A

Depletion envelope

Source

Drain

Pre-saturation

$I_D$

Saturation

IGZO

Gate Dielectric

Gate

## Fig. 4B

**Fig. 4C**

**Fig. 4D**

Fig. 5A

Fig. 5B

**Fig. 5C**

**Fig. 5D**

**Fig. 6A**

**Fig. 6B**

**Fig. 6C**

**Fig. 6D**

**Fig. 7**

**Fig. 8A**

**Fig. 8B**

Fig. 9A

σ = 0.08 eV

Fig. 9B

Fig. 9C

**Fig. 10**

**Fig. 11A**

**Fig. 11B**

**Fig. 11C**

**Fig. 11D**

S801

**Fig. 12**

S901

S902

**Fig. 13**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2339638 A1
- US 2010258802 A1
- US 2017250287 A1